# EUROPEAN PATENT SPECIFICATION

(11) **EP 4 279 492 B1**
(45) Date of publication and mention of the grant of the patent: **01.01.2025**
(21) Application number: 22781631.1
(22) Date of filing: 31.03.2022
(51) Int. Cl.: C09K 11/06, C07F 5/02, H10K 85/60, H10K 50/11

(54) **NOVEL COMPOUND AND ORGANIC LIGHT EMITTING DEVICE COMPRISING SAME**
NEUARTIGE VERBINDUNG UND ORGANISCHE LICHTEMITTIERENDE VORRICHTUNG DAMIT
NOUVEAU COMPOSÉ ET DISPOSITIF ÉLECTROLUMINESCENT ORGANIQUE LE COMPRENANT

(30) Priority: 02.04.2021 KR 20210043425
(43) Date of publication of application: 22.11.2023
(73) Proprietor: LG Chem, Ltd., Seoul 07336 (KR)
(72) Inventor: KIM, Young Kwang, Daejeon 34122 (KR); LEE, Jaechol, Daejeon 34122 (KR); KIM, Yongwook, Daejeon 34122 (KR); YU, Soyoung, Daejeon 34122 (KR); KIM, Shin Sung, Daejeon 34122 (KR); LIM, Byeong Yun, Daejeon 34122 (KR); JEONG, Su Hun, Daejeon 34122 (KR)
(74) Representative: Hoffmann Eitle
(86) International application number: PCT/KR2022/004565
(87) International publication number: WO 2022/211512

(56) References cited:
- EP-A1- 3 696 246
- EP-A1- 3 712 158
- EP-A1- 3 738 966
- WO-A1-2020/108899
- WO-A1-2020/108899
- WO-A1-2020/138875
- WO-A1-2021/013986
- WO-A1-2021/020942
- CN-A- 112 480 154
- CN-A- 112 480 154
- KR-A- 20180 134 850
- KR-A- 20200 107 782
- KR-A- 20200 107 782
- KR-B1- 101 876 763

## Description

### [TECHNICAL FIELD]

### CROSS-REFERENCE TO RELATED APPLICATION(S)

This application claims the benefit of and priority of Korean Patent Application No. 10-2021-0043425 filed on April 2, 2021 with the Korean Intellectual Property Office.

The present disclosure relates to a novel compound and an organic light emitting device comprising the same.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer, and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

For the organic materials used in the organic light emitting devices as described above, the development of new materials is continuously required.

Meanwhile, recently, in order to reduce process costs, an organic light emitting device using a solution process, particularly an inkjet process, has been developed instead of a conventional deposition process. In the initial stage of development, attempts have been made to develop organic light emitting devices by coating all organic light emitting device layers by a solution process, but current technology has limitations. Therefore, only HIL, HTL, and EML are processed by a solution process, and a hybrid process utilizing traditional deposition processes is being studied as a subsequent process.

Therefore, the present disclosure provides a novel material for an organic light emitting device that can be used for an organic light emitting device and at the same time, can be used for a solution process.

### [Prior Art Literature]

### [Patent Literature]

(Patent Literature 1) Korean Unexamined Patent Publication No. 10-2000-0051826
(Patent Literature 2) CN 112 480 154 A discloses a compound comprising boron and nitrogen.

### [DETAILED DESCRIPTION OF THE INVENTION]

### [Technical Problem]

It is an object of the present disclosure to provide a novel compound and an organic light emitting device comprising the same.

### [Technical Solution]

According to an aspect of the present disclosure, there is provided a compound represented by the following Chemical Formula 1:

### [Chemical Formula 1]

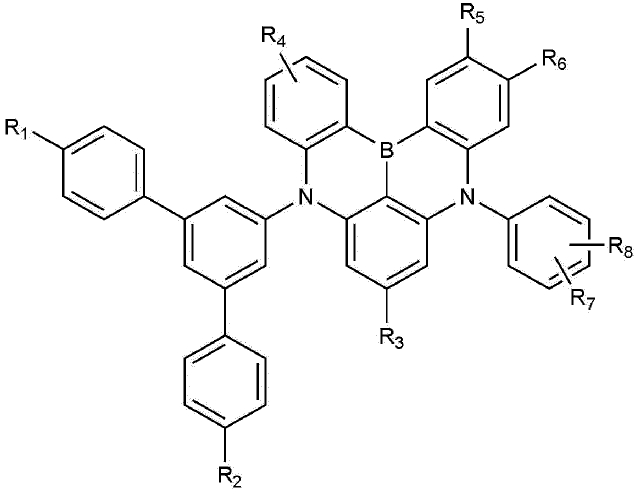

in Chemical Formula 1,
R₁ and R₂ are each independently a substituted or unsubstituted C₁₋₆₀ alkyl,
R₃ is hydrogen; deuterium; halogen; cyano; a substituted or unsubstituted C₁₋₆₀ alkyl; or -N(Ar₁)(Ar₂),
   wherein the Ar₁ and Ar₂ are each independently a substituted or unsubstituted C₆₋₆₀ aryl; or a substituted or unsubstituted C₂₋₆₀ heteroaryl containing any one or more heteroatoms selected from the group consisting of N, O and S,
each R₄ is independently hydrogen; deuterium; halogen; cyano; a substituted or unsubstituted C₁₋₆₀ alkyl; a substituted or unsubstituted C₆₋₆₀ aryl; or a substituted or unsubstituted C₂₋₆₀ heteroaryl containing any one or more heteroatoms selected from the group consisting of N, O and S,
R₅ and R₆ are each independently hydrogen; deuterium; halogen; cyano; a substituted or unsubstituted C₁₋₆₀ alkyl; a substituted or unsubstituted C₆₋₆₀ aryl; or a substituted or unsubstituted C₂₋₆₀ heteroaryl containing any one or more heteroatoms selected from the group consisting of N, O and S; or R₅ and R₆ are connected to each other to form a substituted or unsubstituted C₃₋₁₀ alicyclic ring, and
R₇ and R₈ are each independently hydrogen; deuterium; halogen; cyano; a substituted or unsubstituted C₁₋₆₀ alkyl; a substituted or unsubstituted C₆₋₆₀ aryl; or a substituted or unsubstituted C₂₋₆₀ heteroaryl containing any one or more heteroatoms selected from the group consisting of N, O and S; or R₇ and R₈ are connected to each other to form a substituted or unsubstituted C₃₋₁₀ alicyclic ring or a substituted or unsubstituted C₆₋₁₀ aromatic ring.

According to another aspect of the present disclosure, there is provided an organic light emitting device comprising: a first electrode; a second electrode that is provided opposite to the first electrode; and one or more organic material layers that are provided between the first electrode and the second electrode, wherein one or more layers of the organic material layers include the compound represented by Chemical Formula 1.

### [ADVANTAGEOUS EFFECTS]

The above-mentioned compound represented by Chemical Formula 1 can be used as a material for an organic material layer of an organic light emitting device, can be used in a solution process, and can improve the efficiency, achieve low driving voltage and/or improve lifetime characteristics in the organic light emitting device.

### [BRIEF DESCRIPTION OF THE DRAWINGS]

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a hole transport layer 6, a light emitting layer 7, an electron injection and transport layer 8, and a cathode 4.

### [DETAILED DESCRIPTION OF THE EMBODIMENTS]

Hereinafter, embodiments of the present disclosure will be described in more detail to facilitate understanding of the invention.

### (Definition of Terms)

As used herein, the notation 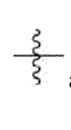 and 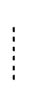 mean a bond linked to another substituent group.

As used herein, the term "substituted or unsubstituted" means being unsubstituted or substituted with one or more substituents selected from the group consisting of deuterium; a halogen group; a cyano group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heteroaryl containing at least one of N, O and S atoms, or being unsubstituted or substituted with a substituent to which two or more substituents of the above-exemplified substituents are linked. For example, "a substituent in which two or more substituents are linked" may be a biphenyl group. Namely, a biphenyl group may be an aryl group, or it may also be interpreted as a substituent in which two phenyl groups are linked.

In the present disclosure, the carbon number of a carbonyl group is not particularly limited, but is preferably 1 to 40. Specifically, the carbonyl group may be a substituent group having the following structural formulas, but is not limited thereto.

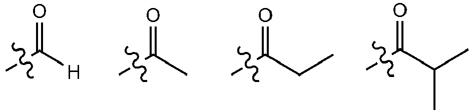

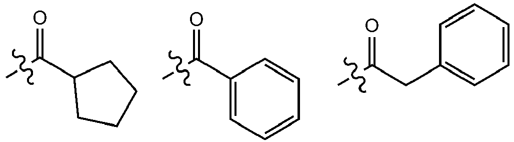

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a substituent group having the following structural formulas, but is not limited thereto.

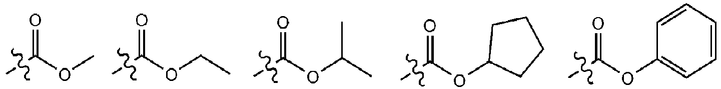

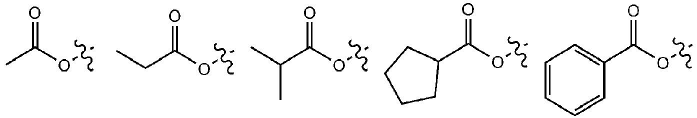

In the present disclosure, the carbon number of an imide group is not particularly limited, but is preferably 1 to 25. Specifically, the imide group may be a substituent group having the following structural formulas, but is not limited thereto.

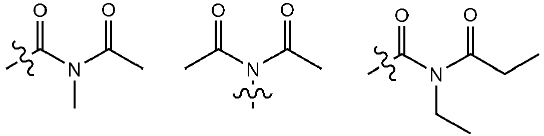

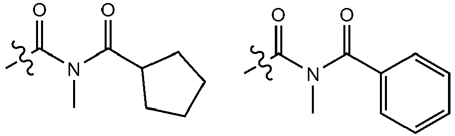

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methylbutyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthryl group, a pyrenyl group, a perylenyl group, a chrysenyl group, a fluorenyl group, or the like, but is not limited thereto.

In the present disclosure, the fluorenyl group may be substituted, and two substituents may be connected to each other to form a spiro structure. In the case where the fluorenyl group is substituted, 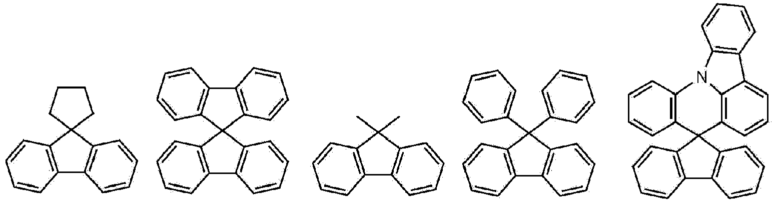 and the like can be formed. However, the structure is not limited thereto

In the present disclosure, a heteroaryl is a heteroaryl containing at least one of O, N, Si and S as a heteroatom, and the carbon number thereof is not particularly limited, but is preferably 2 to 60. Examples of the heteroaryl include xanthene, thioxanthene, a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group, the arylamine group and the arylsily group is the same as the above-mentioned examples of the aryl group. In the present disclosure, the alkyl group in the aralkyl group, the alkylaryl group and the alkylamine group is the same as the above-mentioned examples of the alkyl group. In the present disclosure, the heteroaryl in the heteroarylamine may be applied to the above-mentioned description of the heteroaryl. In the present disclosure, the alkenyl group in the aralkenyl group is the same as the above-mentioned examples of the alkenyl group. In the present disclosure, the above-mentioned description of the aryl group may be applied except that the arylene is a divalent group. In the present disclosure, the above-mentioned description of the heteroaryl may be applied except that the heteroarylene is a divalent group. In the present disclosure, the above-mentioned description of the aryl group or cycloalkyl group may be applied except that the hydrocarbon ring is not a monovalent group but formed by combining two substituent groups. In the present disclosure, the above-mentioned description of the heteroaryl may be applied, except that the heterocyclic group is not a monovalent group but formed by combining two substituent groups.

### (Compound)

The present disclosure provides the compound represented by Chemical Formula 1.

Preferably, R₁ and R₂ are each independently a substituted or unsubstituted C₁₋₁₀ alkyl.

Preferably, R₁ and R₂ are each independently methyl, ethyl, propyl, isopropyl, butyl, isobutyl, tertbutyl, or 2,4,4-trimethylpentan-2-yl.

Preferably, R₁ and R₂ are the same as each other.

Preferably, R₃ is hydrogen, deuterium, fluoro, chloro, cyano, or methyl.

Preferably, R₃ is -N(Ar₁)(Ar₂), and Ar₁ and Ar₂ are each independently phenyl, biphenylyl, terphenylyl, dimethylfluorenyl, diphenylfluorenyl, dimethylbenzofluorenyl, diphenylbenzofluorenyl, dibenzofuranyl, or dibenzothiophenyl. At this time, the Ar₁ and Ar₂ are each independently unsubstituted or substituted with one or two C₁₋₁₀ alkyls, more preferably, are each independently unsubstituted or substituted with one or two of methyl, ethyl, propyl, isopropyl, butyl, isobutyl, tertbutyl, or 2,4,4-trimethylpentan-2-yl.

Preferably, R₄ is hydrogen, deuterium, or a substituted or unsubstituted C₁₋₁₀ alkyl. More preferably, R₄ is hydrogen, deuterium, methyl, ethyl, propyl, isopropyl, butyl, isobutyl, tertbutyl, or 2,4,4-trimethylpentan-2-yl.

Preferably, R₅ and R₆ are each independently hydrogen, deuterium, or a substituted or unsubstituted C₁₋₁₀ alkyl; or R₅ and R₆ are connected to each other to form

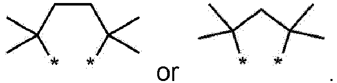

Preferably, R₅ and R₆ are each independently hydrogen, deuterium, methyl, ethyl, propyl, isopropyl, butyl, isobutyl, tertbutyl, or 2,4,4-trimethylpentan-2-yl; or R₅ and R₆ are connected to each other to form 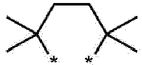 or

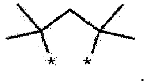

Preferably, R₅ is a substituted or unsubstituted C₁₋₁₀ alkyl, R₆ is hydrogen or deuterium. More preferably, R₅ is methyl, ethyl, propyl, isopropyl, butyl, isobutyl, tertbutyl, or 2,4,4-trimethylpentan-2-yl, and R₆ is hydrogen or deuterium.

Preferably, R₇ and R₈ are each independently hydrogen, deuterium, a substituted or unsubstituted C₁₋₁₀alkyl, or phenyl unsubstituted or substituted with a C₁₋₁₀ alkyl; or R₇ and R₈ are connected to each other to form

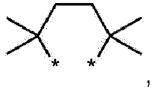

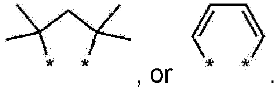

Preferably, R₇ and R₈ are each independently hydrogen, deuterium, methyl, ethyl, propyl, isopropyl, butyl, isobutyl, tertbutyl, 2,4,4-trimethylpentan-2-yl, or 4-(tertbutyl) phenyl.

Representative examples of the compound represented by Chemical Formula 1 are as follows.

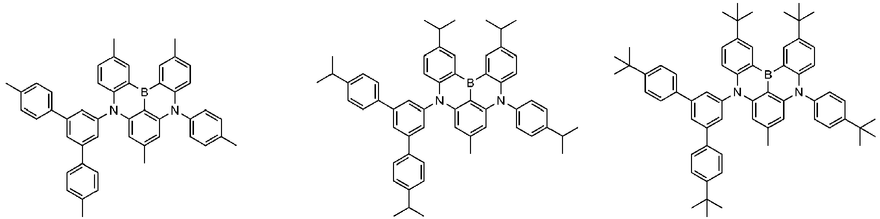

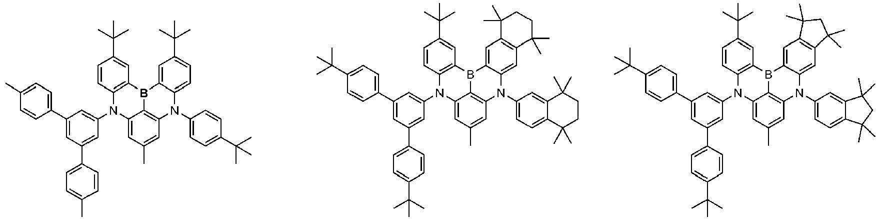

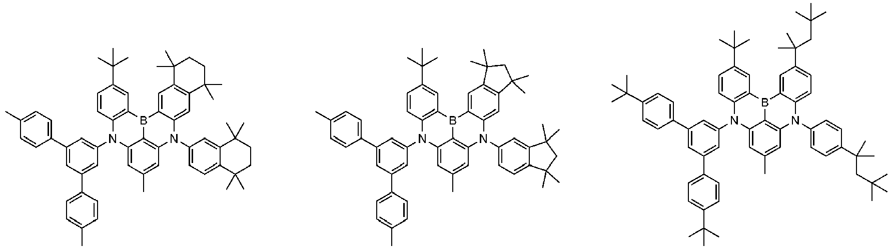

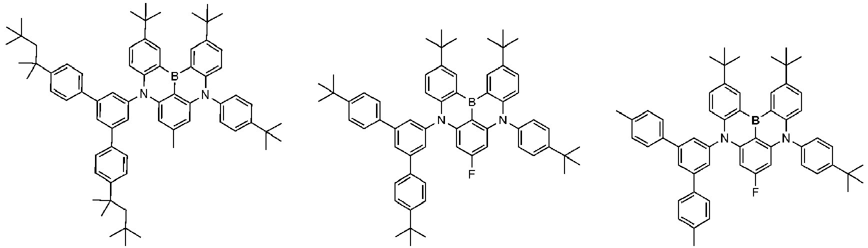

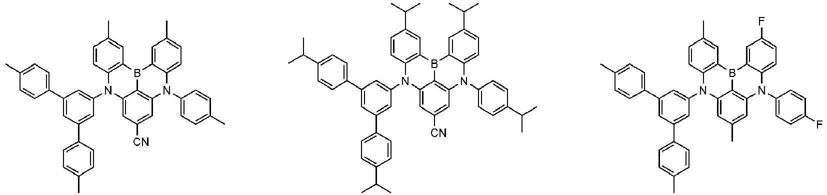

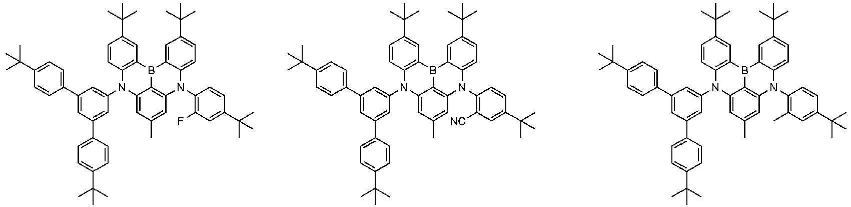

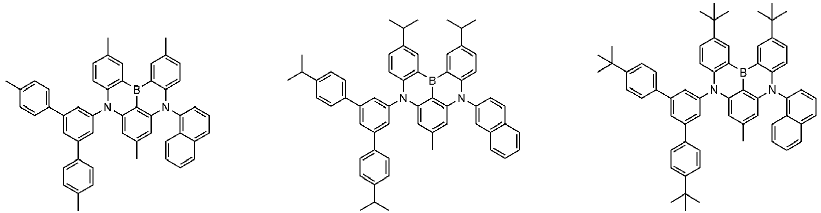

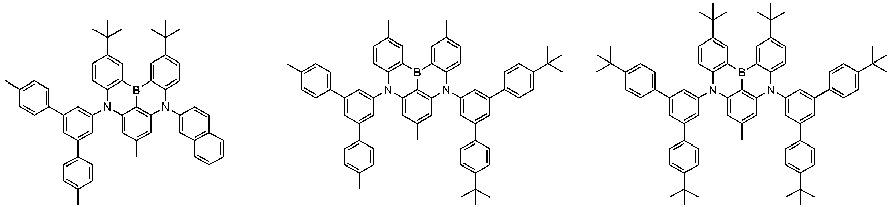

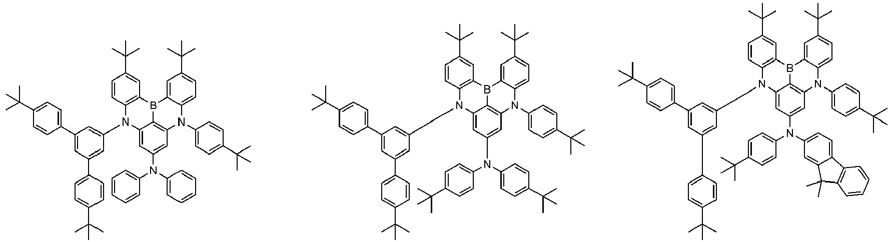

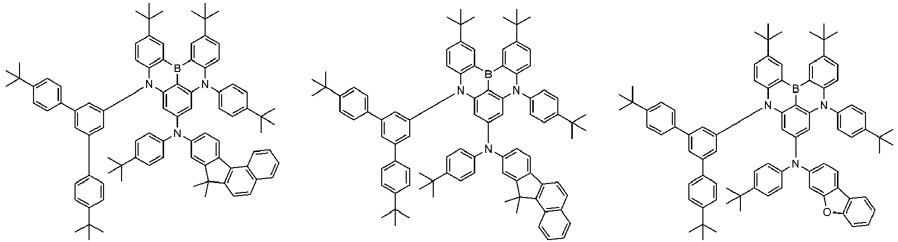

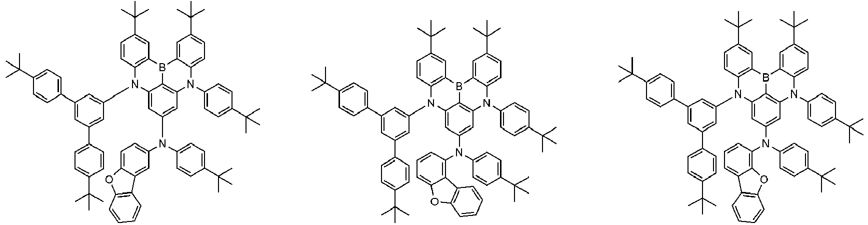

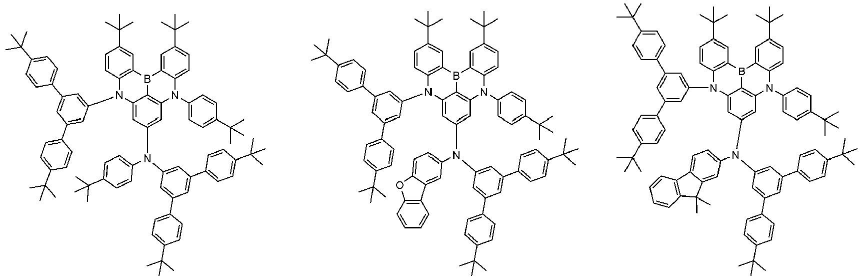

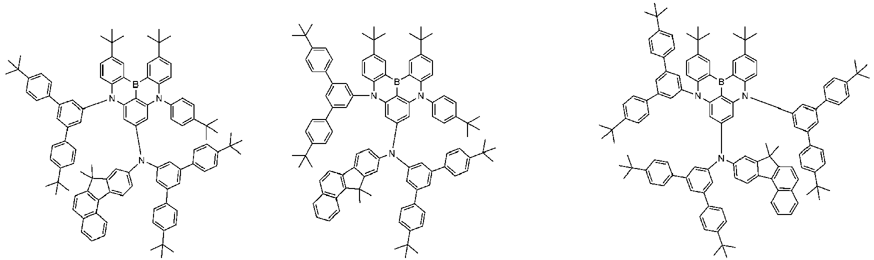

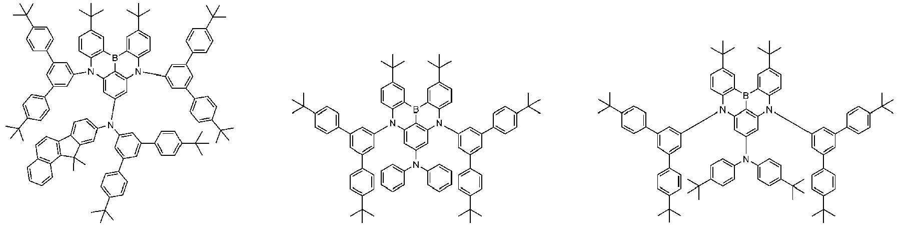

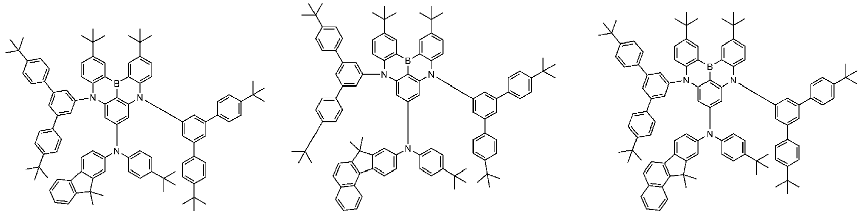

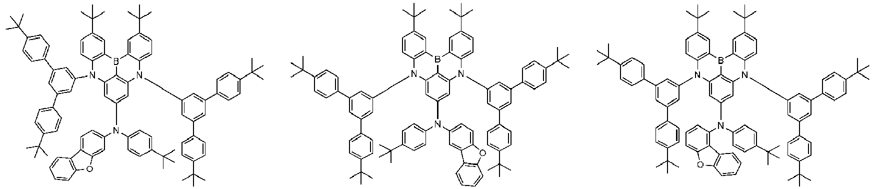

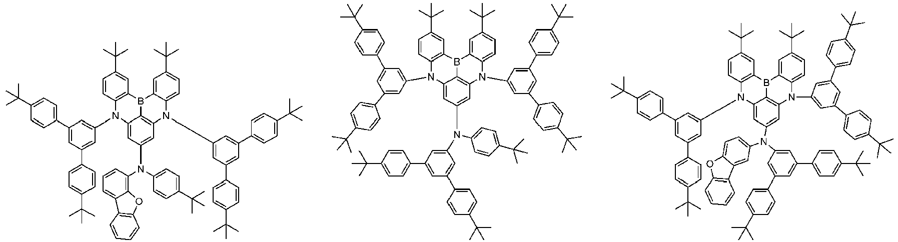

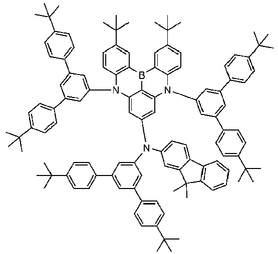

Meanwhile, the present disclosure provides a method for preparing the compound represented by Chemical Formula 1, as shown in the following Reaction Scheme 1 as an example.

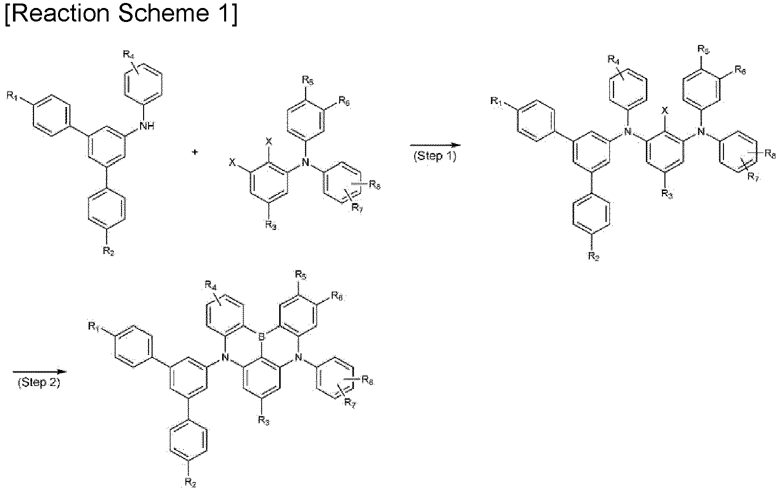

In Reaction Scheme 1, the definition of the remaining substituents except for X are the same as defined above, and X is halogen, preferably bromo or chloro.

Step 1 is an amine substitution reaction, which is preferably carried out in the presence of a palladium catalyst and a base, and a reactive group for the amine substitution reaction can be modified as known in the art. Step 2 is a reaction with BI₃, which is preferably carried out in the presence of a base. The above preparation method may be further embodied in Preparation Examples described hereinafter.

### (Coating Composition)

Meanwhile, the compound according to the present disclosure can form an organic material layer, particularly a light emitting layer, of an organic light emitting device by a solution process. For this purpose, the present disclosure provides a coating composition including the above-mentioned compound according to the present disclosure and a solvent.

The solvent is not particularly limited as long as it is a solvent capable of dissolving or dispersing the compound according to the present disclosure. Examples of the solvent may include chlorine-based solvents such as chloroform, methylene chloride, 1,2-dichloroethane, 1,1,2-trichloroethane, chlorobenzene and o-dichlorobenzene; ether-based solvents such as tetrahydrofuran and dioxane; aromatic hydrocarbon-based solvents such as toluene, xylene, trimethylbenzene, and mesitylene; aliphatic hydrocarbon-based solvents such as cyclohexane, methylcyclohexane, n-pentane, n-hexane, n-heptane, n-octane, n-nonane and n-decane; ketone-based solvents such as acetone, methyl ethyl ketone, and cyclohexanone; ester-based solvents such as ethyl acetate, butyl acetate and ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol, and derivatives thereof; alcohol-based solvents such as methanol, ethanol, propanol, isopropanol and cyclohexanol; sulfoxide-based solvents such as dimethyl sulfoxide; amide-based solvents such as N-methyl-2-pyrrolidone and N,N-dimethylformamide; benzoate-based solvents such as butylbenzoate, and methyl-2-methoxybenzoate; tetraline; 3-phenoxy-toluene, and the like. In addition, the above-mentioned solvents may be used singly or in combination of two or more solvents.

Further, the coating composition may further include a compound used as a host material, and the compound used for the host material will be described later. Further, the coating composition may include a compound used as a dopant material, and the compound used for the dopant material will be described later.

Further, the viscosity of the coating composition is preferably 1 cP to 10 cP, and coating is easily carried out in the above range. Moreover, the concentration of the compound according to the present disclosure in the coating composition is preferably 0.1 wt/v% to 20 wt/v%.

In another embodiment of the present disclosure, there is provided a method for forming a light emitting layer using the above-mentioned coating composition. Specifically, the method includes the steps of: coating the above-mentioned light emitting layer according to the present disclosure onto the anode by a solution process; and heat-treating the coated coating composition.

The solution process uses the above-mentioned coating composition according to the present disclosure, and refers to spin coating, dip coating, doctor blading, inkjet printing, screen printing, spray method, roll coating, and the like, but is not limited thereto.

The heat treatment temperature in the heat treatment step is preferably from 150 to 230°C. Further, a heat treatment time may be 1 minute to 3 hours, more preferably 10 minutes to 1 hour. Further, the heat treatment is preferably carried out in an inert gas atmosphere such as argon and nitrogen.

### (Organic Light Emitting Device)

In another embodiment of the present disclosure, there is provided an organic light emitting device including the compound represented by Chemical Formula 1. In one example, the present disclosure provides an organic light emitting device comprising: a first electrode; a second electrode that is provided opposite to the first electrode; and one or more organic material layers that are provided between the first electrode and the second electrode, wherein one or more layers of the organic material layers include the compound represented by Chemical Formula 1.

The organic material layer of the organic light emitting device of the present disclosure may have a single-layer structure, or it may have a multilayered structure in which two or more organic material layers are stacked. For example, the organic light emitting device of the present disclosure may have a structure comprising a hole injection layer, a hole transport layer, a light emitting layer, an electron transport layer, an electron injection layer and the like as the organic material layer. However, the structure of the organic light emitting device is not limited thereto, and it may include a smaller number of organic layers.

Further, the organic material layer may include a light emitting layer, wherein the light emitting layer may include the compound represented by Chemical Formula 1. Particularly, the compound according to the present disclosure can be used as a dopant of the light emitting layer.

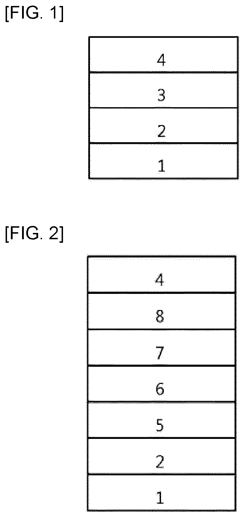

Further, the organic light emitting device according to the present disclosure may be a normal type organic light emitting device in which an anode, one or more organic material layers and a cathode are sequentially stacked on a substrate. Further, the organic light emitting device according to the present disclosure may be an inverted type organic light emitting device in which a cathode, one or more organic material layers and an anode are sequentially stacked on a substrate. For example, the structure of an organic light emitting device according to an embodiment of the present disclosure is illustrated in FIGS. 1 and 2.

FIG. 1 shows an example of an organic light emitting device comprising a substrate 1, an anode 2, a light emitting layer 3, and a cathode 4. In such a structure, the compound represented by Chemical Formula 1 may be included in the light emitting layer.

FIG. 2 shows an example of an organic light emitting device comprising a substrate 1, an anode 2, a hole injection layer 5, a hole transport layer 6, a light emitting layer 7, an electron injection and transport layer 8, and a cathode 4. In such a structure, the compound represented by Chemical Formula 1 may be included in the light emitting layer.

The organic light emitting device according to the present disclosure may be manufactured by materials and methods known in the art, except that at least one of the organic material layers includes the compound represented by Chemical Formula 1. Further, when the organic light emitting device includes a plurality of organic material layers, the organic material layers may be formed of the same material or different materials.

For example, the organic light emitting device according to the present disclosure can be manufactured by sequentially stacking an anode, an organic material layer and a cathode on a substrate. In this case, the organic light emitting device may be manufactured by depositing a metal, metal oxides having conductivity, or an alloy thereof on the substrate using a PVD (physical vapor deposition) method such as a sputtering method or an e-beam evaporation method to form an anode, forming organic material layers including the hole injection layer, the hole transport layer, the light emitting layer and the electron transport layer thereon, and then depositing a material that can be used as the cathode thereon.

In addition to such a method, the organic light emitting device may be manufactured by sequentially depositing a cathode material, an organic material layer and an anode material on a substrate (International Publication WO 2003/012890). However, the manufacturing method is not limited thereto.

In one example, the first electrode is an anode, and the second electrode is a cathode, or alternatively, the first electrode is a cathode and the second electrode is an anode.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive compounds such as poly(3-methylthiophene), poly[3,4-(ethylene-1,2-dioxy)thiophene] (PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

The hole injection layer is a layer for injecting holes from the electrode, and the hole injection material is preferably a compound which has a capability of transporting the holes, thus has a hole injecting effect in the anode and an excellent hole injecting effect to the light emitting layer or the light emitting material, prevents excitons produced in the light emitting layer from moving to a hole injection layer or the electron injection material, and further is excellent in the ability to form a thin film. It is preferable that a HOMO (highest occupied molecular orbital) of the hole injection material is between the work function of the anode material and a HOMO of a peripheral organic material layer. Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

The hole transport layer is a layer that receives holes from a hole injection layer and transports the holes to the light emitting layer. The hole transport material is suitably a material having large mobility to the holes, which may receive holes from the anode or the hole injection layer and transfer the holes to the light emitting layer. Specific examples thereof include an arylamine-based organic material, a conductive compound, a block copolymer in which a conjugate portion and a non-conjugate portion are present together, and the like, but are not limited thereto.

The light emitting layer may include a host material and a dopant material. The host material may be a fused aromatic ring derivative, a heterocycle-containing compound or the like. Specific examples of the fused aromatic ring derivatives include anthracene derivatives, pyrene derivatives, naphthalene derivatives, pentacene derivatives, phenanthrene compounds, fluoranthene compounds, and the like. Examples of the heterocyclic-containing compounds include carbazole derivatives, dibenzofuran derivatives, ladder-type furan compounds, pyrimidine derivatives, and the like, but are not limited thereto.

Examples of the dopant material include an aromatic amine derivative, a styrylamine compound, a boron complex, a fluoranthene compound, a metal complex, and the like. Specifically, the aromatic amine derivative is a substituted or unsubstituted fused aromatic ring derivative having an arylamino group, and examples thereof include pyrene, anthracene, chrysene, periflanthene and the like, which have an arylamino group. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, the metal complex includes an iridium complex, a platinum complex, and the like, but is not limited thereto.

The electron injection and transport layer is a layer for simultaneously performing the roles of an electron transport layer and an electron injection layer that inject electrons from an electrode and transport the received electrons up to the light emitting layer, and is formed on the light emitting layer or the electron adjustment layer. The electron injection and transport material is suitably a material which can receive electrons well from a cathode and transfer the electrons to a light emitting layer, and has a large mobility for electrons. Specific examples of the electron injection and transport material include: an Al complex of 8-hydroxyquinoline; a complex including Alq₃; an organic radical compound; a hydroxyflavone-metal complex, a triazine derivative, and the like, but are not limited thereto. Alternatively, LiF, NaF, NaCl, CsF, Li₂O, BaO, fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like can be used, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

The organic light emitting device according to the present disclosure may be a bottom emission device, a top emission device, or a double-sided light emitting device, and in particular, may be a bottom emission device that requires relatively high luminous efficiency.

In addition, the compound according to the present disclosure may be included in an organic solar cell or an organic transistor in addition to an organic light emitting device.

The preparation of the compound represented by Chemical Formula 1 and the organic light emitting device including the same will be specifically described in the following Examples. However, the following Examples are provided for illustrative purposes only, and are not intended to limit the scope of the present disclosure.

### [EXAMPLE]

### Example 1: Preparation of Compound BD1

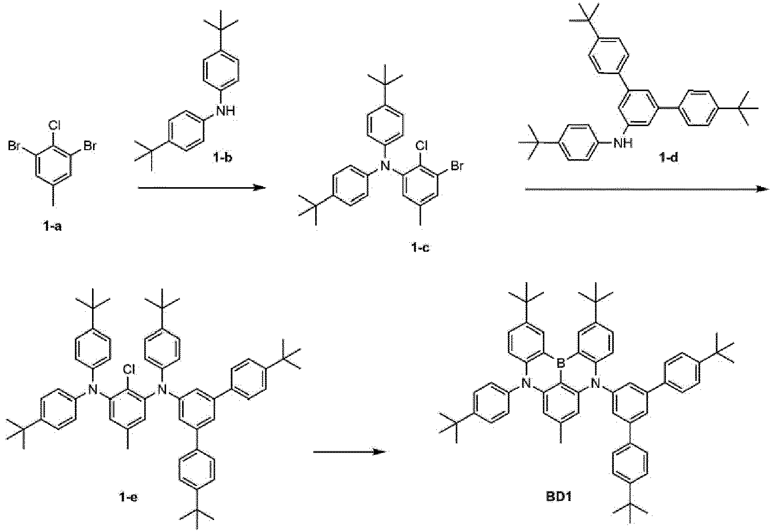

Compound 1-a (1.1 eq.), NaOt-Bu (2.0 eq.), and Compound 1-b (1.0 eq.) were placed in a round bottom flask and dissolved in anhydrous toluene (0.05 M). Pd(*t*-Bu₃P)₂ (5 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 1-c (Yield: 80%).

Compound 1-c (1 eq.), NaOt-Bu (2.0 eq.), and Compound 1-d (1.0 eq.) were placed in a round bottom flask and dissolved in anhydrous toluene (0.05 M). Pd(*t*-Bu₃P)₂(5 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 1-e (Yield: 82%).

Compound 1-e (1.0 eq.) was placed in a round bottom flask and dissolved in anhydrous toluene (0.03 M). BI₃(2.0 eq.) was slowly added dropwise to the reaction solution, and the mixture was stirred at a bath temperature of 80°C overnight. After the reaction, the reaction mixture was sufficiently cooled at room temperature and diluted with CH₂Cl₂. EtN*i*-Pr₂(15.0 eq.) and sat.Na₂S₂O₃(aq.) were sequentially added dropwise to the reaction mixture, and washed with CH₂Cl₂/H₂O. The organic layer was separated, water was removed with MgSO₄ and passed through a Celite-Florisil-Silica pad. The passed solution was concentrated under reduced pressure, and then purified by column chromatography to prepare Compound BD1 (Yield: 60%).
m/z [M+H]⁺ 866.57

### Example 2: Preparation of Compound BD2

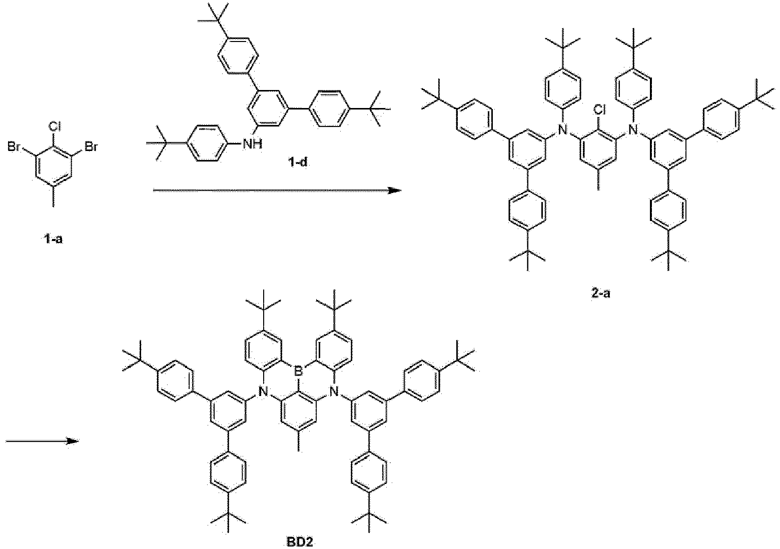

Compound 1-a(1.0 eq.), NaO*t*-Bu (4.0 eq.), and Compound 1-d (2.0 eq.) were placed in a round bottom flask and dissolved in anhydrous toluene (0.05 M). Pd(*t*-Bu₃P)₂ (10 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 2-a (Yield: 70%).

Subsequently, Compound BD2 was prepared in the same manner as in the preparation method of Compound BD1, except that Compound 2-a was used instead of Compound 1-e.
m/z [M+H]⁺ 1074.7

### Example 3: Preparation of Compound BD3

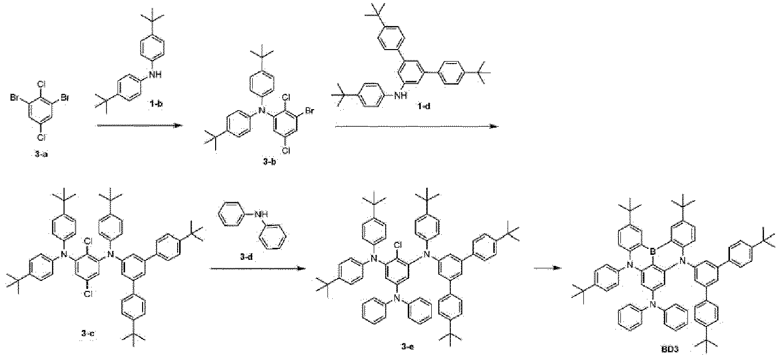

Compound 3-a (1.1 eq.), NaOt-Bu (2.0 eq.), and Compound 1-b (1.0 eq.) were placed in a round bottom flask and dissolved in anhydrous toluene (0.05 M). Pd(*t*-Bu₃P)₂ (5 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 3-b (Yield: 80%).

Compound 3-b (1 eq.), NaO*t*-Bu (2.0 eq.), and Compound 1-d (1.0 eq.) were placed in a round bottom flask and dissolved in anhydrous toluene (0.05 M). Pd(*t*-Bu₃P)₂(5 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 3-c (Yield: 74%).

Compound 3-c (1 eq.), NaOt-Bu (2.0 eq.), and Compound 3-d (1.0 eq.) were placed in a round bottom flask and dissolved in anhydrous toluene (0.05 M). Pd(*t*-Bu₃P)₂(5 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 3-e (Yield: 72%).

Compound 3-e (1.0 eq.) was placed in a round bottom flask and dissolved in anhydrous toluene (0.03 M). BI₃(2.0 eq.) was slowly added dropwise to the reaction solution, and the mixture was stirred at a bath temperature of 80°C overnight. After the reaction, the reaction mixture was sufficiently cooled at room temperature and diluted with CH₂Cl₂. EtN*i*-Pr₂ (15.0 eq.) and sat.Na₂S₂O₃(aq.) were sequentially added dropwise to the reaction mixture, and washed with CH₂Cl₂/H₂O. The organic layer was separated, water was removed with MgSO₄ and passed through a Celite-Florisil-Silica pad. The passed solution was concentrated under reduced pressure, and then purified by column chromatography to prepare Compound BD3 (Yield: 65%).
m/z [M+H]⁺ 1019.6

### Example 4: Preparation of Compound BD4

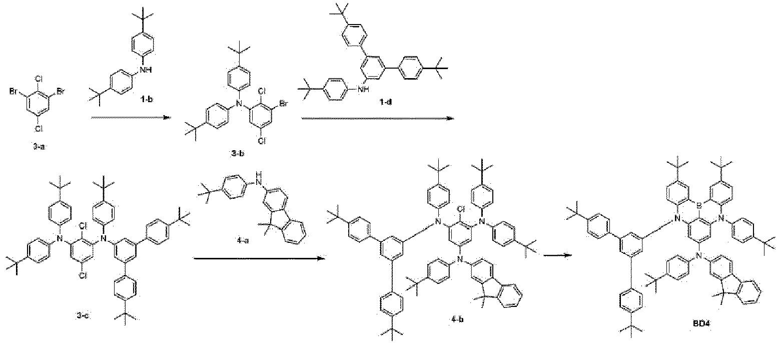

Compound BD4 was prepared in the same manner as in the preparation method of Compound BD3, except that Compound 4-a was used instead of Compound 3-d.
m/z [M+H]⁺ 1191.7

### Example 5: Preparation of Compound BD5

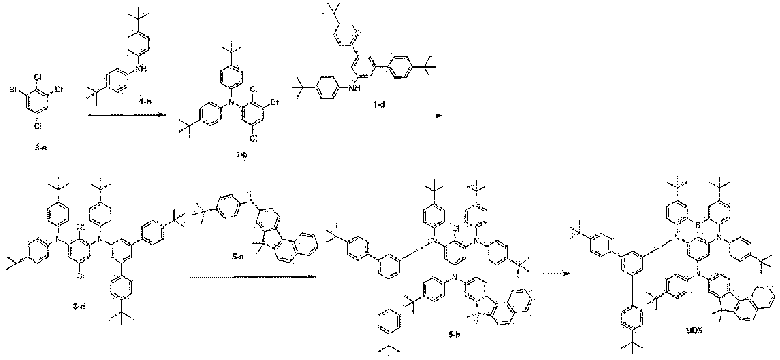

Compound BD5 was prepared in the same manner as in the preparation method of Compound BD3, except that Compound 5-a was used instead of Compound 3-d.
m/z [M+H]⁺ 1241.7

### Example 6: Preparation of Compound BD6

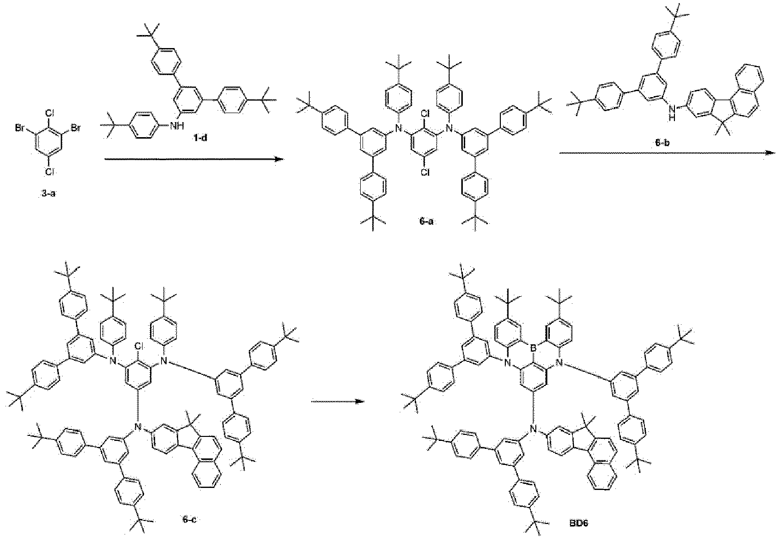

Compound 3-a (1 eq.), NaO*t*-Bu (4.0 eq.), and Compound 1-d (2.0 eq.) were placed in a round bottom flask and dissolved in anhydrous toluene (0.05 M). Pd(*t*-Bu₃P)₂ (10 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound 6-a (Yield: 70%).

Compound BD6 was prepared in the same manner as in the preparation method of Compound BD3, except that Compound 6-b was used instead of Compound 3-d.
m/z [M+H]⁺ 1658

### [COMPARATIVE EXAMPLE]

### Comparative Example 1: Preparation of Compound F

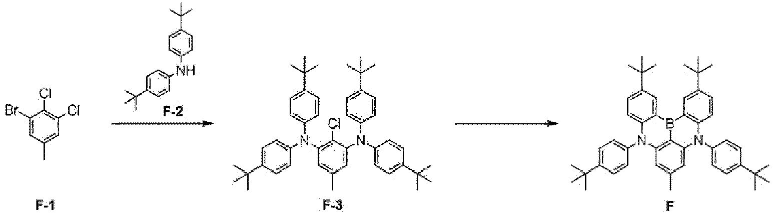

Compound F-1 (1.0 eq.), NaO*t*-Bu (4.0 eq.), and Compound F-2 (2.05 eq.) were placed in a round bottom flask and dissolved in anhydrous toluene (0.1 M). Pd(*t*-Bu₃P)₂ (5 mol%) was added dropwise thereto at a bath temperature of 120°C, and the mixture was stirred for 3 days. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound F-3 (Yield: 75%).

Compound F-3 (1.0 eq.) was placed in a round bottom flask and dissolved in anhydrous toluene (0.03 M). BI₃(2.0 eq.) was slowly added dropwise to the reaction solution, and the mixture was stirred at a bath temperature of 80°C overnight. After the reaction, the reaction mixture was sufficiently cooled at room temperature and diluted with CH₂Cl₂. EtN*i*-Pr₂ (15.0 eq.) and sat.Na₂S₂O₃(aq.) were sequentially added dropwise to the reaction mixture, and washed with CH₂Cl₂/H₂O. The organic layer was separated, water was removed with MgSO₄ and passed through a Celite-Florisil-Silica pad. The passed solution was concentrated under reduced pressure, and then purified by column chromatography to prepare Compound F (Yield: 87%).
m/z [M+H]⁺= 659.6

### Comparative Example 2: Preparation of Compound G

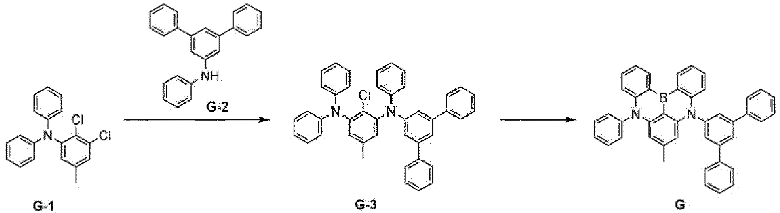

Compound G-1 (1.0 eq.), NaOt-Bu (4.0 eq.), and Compound G-2 (1.05 eq.) were placed in a round bottom flask and dissolved in anhydrous toluene (0.1 M). Pd(*t*-Bu₃P)₂ (5 mol%) was added dropwise thereto at a bath temperature of 120°C, and the mixture was stirred overnight. After the reaction, the reaction mixture was cooled at room temperature, sufficiently diluted with CH₂Cl₂, and then washed with CH₂Cl₂/brine. The organic layer was separated, water was removed with MgSO₄ and passed through a Celite-Florisil-Silica pad. The passed solution was concentrated under reduced pressure, and then purified by column chromatography to prepare Compound G-3 (Yield: 79%).

Compound G-3 (1.0 eq.) was placed in a round bottom flask and dissolved in anhydrous toluene (0.03 M). BI₃(2.0 eq.) was slowly added dropwise to the reaction solution, and the mixture was stirred at a bath temperature of 80°C overnight. After the reaction, the reaction mixture was sufficiently cooled at room temperature and diluted with CH₂Cl₂. EtN*i*-Pr₂ (15.0 eq.) and sat.Na₂S₂O₃(aq.) were sequentially added dropwise to the reaction mixture, and washed with CH₂Cl₂/H₂O. The organic layer was separated, water was removed with MgSO₄ and passed through a Celite-Florisil-Silica pad. The passed solution was concentrated under reduced pressure, and then purified by column chromatography to prepare Compound G (Yield: 73%).
m/z [M+H]⁺= 586.2

### [EXPERIMENTAL EXAMPLE]

### Experimental Example 1

A glass substrate on which ITO (indium tin oxide) was coated as a thin film to a thickness of 500 Å was put into distilled water in which a detergent was dissolved, and ultrasonically cleaned. At this time, a product manufactured by Fischer Co. was used as the detergent, and as the distilled water, distilled water filtered twice using a filter manufactured by Millipore Co. was used. After the ITO was cleaned for 30 minutes, ultrasonic cleaning was repeated twice using distilled water for 10 minutes. After the cleaning with distilled water was completed, the substrate was ultrasonically cleaned with solvents of isopropyl alcohol, acetone, and methanol, dried, and then the substrate was cleaned for 5 minutes and then transferred to a glove box.

A coating composition, in which the following compound O and the following compound P (weight ratio of 2:8) were dissolved in cyclohexanone at 20 wt/v%, was spin-coated (4000 rpm) on the ITO transparent electrode, and heat-treated (cured) at 200°C for 30 minutes to form a hole injection layer with a thickness of 400 Å. A coating composition, in which the following polymer Q (Mn: 27,900; Mw: 35,600; measured by GPC (Agilent 1200 series) using PC Standard) was dissolved in toluene at 6 wt/v%, was spin-coated (4000 rpm) on the hole injection layer, and heat-treated at 200°C for 30 minutes to form a hole transport layer with a thickness of 200 Å. A coating composition, in which the previously prepared compound BD1 and the following compound R (weight ratio of 2:98) were dissolved in cyclohexanone at 2 wt/v%, was spin-coated (4000 rpm) on the hole transport layer, and heat-treated at 180°C for 30 minutes to form a light emitting layer with a thickness of 400 Å. After transferring to a vacuum evaporator, the following compounds S was vacuum-deposited on the light emitting layer to a thickness of 350 Å to form an electron injection and transport layer. LiF (10 Å), and aluminum (1000 Å) were sequentially deposited on the electron injection and transport layer to form a cathode.

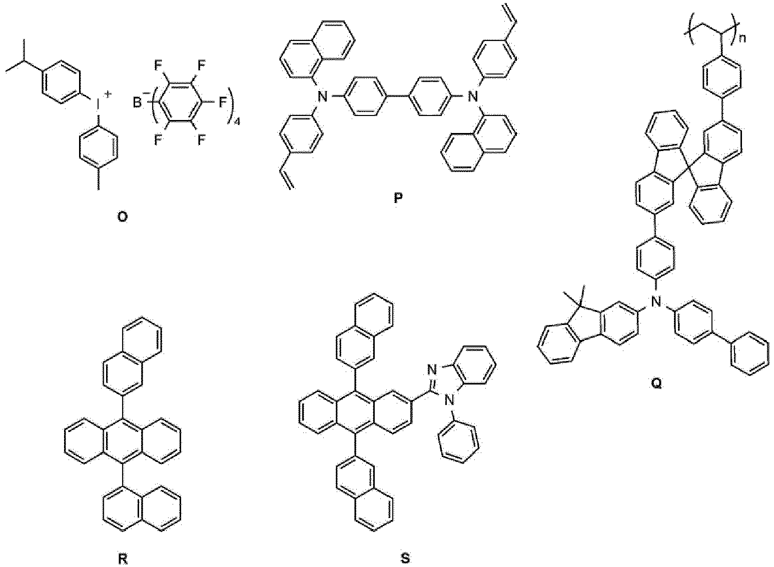

In the above-mentioned process, the vapor deposition rate of the organic material was maintained at 0.4 to 0.7 Å/sec, the deposition rate of LiF was maintained at 0.3 Å/sec, the deposition rate of aluminum was maintained at 2 Å/sec, and the degree of vacuum during the deposition was maintained at 2*10⁻⁷ to 5*10⁻⁸ torr.

### Experimental Examples 2 to 6

An organic light emitting device was manufactured in the same manner as in Experimental Example 1, except that the compounds shown in Table 1 below were used instead of Compound BD1 as a dopant of the light emitting layer.

### Comparative Experimental Examples 1and 2

An organic light emitting device was manufactured in the same manner as in Experimental Example 1, except that the compounds shown in Table 1 below were used instead of Compound BD1 as a dopant of the light emitting layer.

The driving voltage, external quantum efficiency (EQE), and lifetime were measured by applying a current of 10 mA/cm² to the organic light emitting devices manufactured in the Experimental Examples and Experimental Comparative Examples, and the results are shown in Table 1 below. At this time, the external quantum efficiency (EQE) was calculated as "(the number of emitted photon)/(the number of injected charge carrier) * 100", and the lifetime (T90) means the time required for the luminance to be reduced to 90% of the initial luminance (500 nit).

**[Table 1]**

| Category | Dopant of light emitting layer | Driving voltage (V) (@10mA/cm²) | EQE(%) (@10mA/cm²) | Lifetime (T90; hr) (@500 nit) |
|---|---|---|---|---|
| Experimental Example 1 | Compound BD1 | 4.21 | 7.01 | 302 |
| Experimental Example 2 | Compound BD2 | 4.26 | 7.20 | 310 |
| Experimental Example 3 | Compound BD3 | 4.17 | 7.07 | 308 |
| Experimental Example 4 | Compound BD4 | 4.19 | 7.12 | 297 |
| Experimental Example 5 | Compound BD5 | 4.23 | 7.08 | 280 |
| Experimental Example 6 | Compound BD6 | 4.35 | 7.23 | 276 |
| Comparative Experimental Example 1 | Compound F | 4.69 | 4.39 | 105 |
| Comparative Experimental Example 2 | Compound G | 4.53 | 6.85 | 240 |

As shown in Table 1 above, the organic light emitting devices comprising the compounds of the present disclosure as the dopant of the light emitting layer exhibits excellent characteristics in terms of efficiency, driving voltage and lifetime.

### [Description of symbols]

| | | | |
|---|---|---|---|
| 1: | substrate | 2: | anode |
| 3: | light emitting layer | 4: | cathode |
| 5: | hole injection layer | 6: | hole transport layer |
| 7: | light emitting layer | 8: | electron injection and transport layer |

## Claims

1. A compound represented by the following Chemical Formula 1: 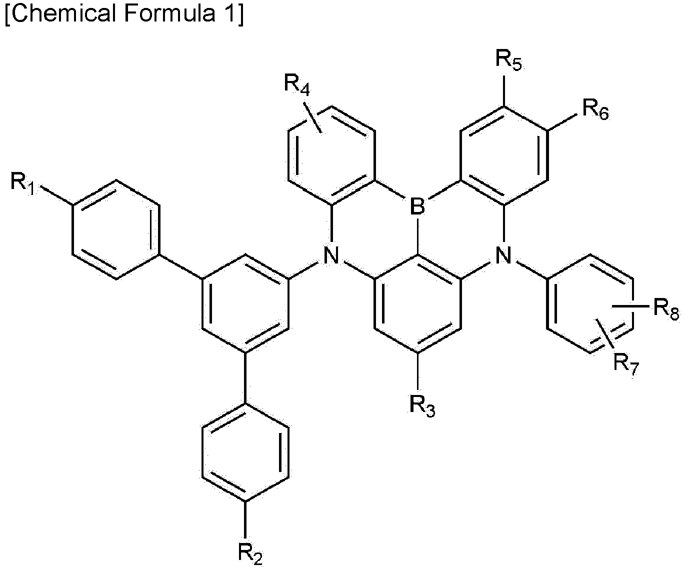
in Chemical Formula 1,
R₁ and R₂ are each independently a substituted or unsubstituted C₁₋₆₀ alkyl,
R₃ is hydrogen; deuterium; halogen; cyano; a substituted or unsubstituted C₁₋₆₀ alkyl; or -N(Ar₁)(Ar₂),
wherein the Ar₁ and Ar₂ are each independently a substituted or unsubstituted C₆₋₆₀ aryl; or a substituted or unsubstituted C₂₋₆₀ heteroaryl containing any one or more heteroatoms selected from the group consisting of N, O and S,
each R₄ is independently hydrogen; deuterium; halogen; cyano; a substituted or unsubstituted C₁₋₆₀ alkyl; a substituted or unsubstituted C₆₋₆₀ aryl; or a substituted or unsubstituted C₂₋₆₀ heteroaryl containing any one or more heteroatoms selected from the group consisting of N, O and S,
R₅ and R₆ are each independently hydrogen; deuterium; halogen; cyano; a substituted or unsubstituted C₁₋₆₀ alkyl; a substituted or unsubstituted C₆₋₆₀ aryl; or a substituted or unsubstituted C₂₋₆₀ heteroaryl containing any one or more heteroatoms selected from the group consisting of N, O and S; or R₅ and R₆ are connected to each other to form a substituted or unsubstituted C₃₋₁₀ alicyclic ring, and
R₇ and R₈ are each independently hydrogen; deuterium; halogen; cyano; a substituted or unsubstituted C₁₋₆₀ alkyl; a substituted or unsubstituted C₆₋₆₀ aryl; or a substituted or unsubstituted C₂₋₆₀ heteroaryl containing any one or more heteroatoms selected from the group consisting of N, O and S; or R₇ and R₈ are connected to each other to form a substituted or unsubstituted C₃₋₁₀ alicyclic ring or a substituted or unsubstituted C₆₋₁₀ aromatic ring.

2. The compound of claim 1, wherein:
R₁ and R₂ are each independently a substituted or unsubstituted C₁₋₁₀ alkyl.

3. The compound of claim 1, wherein:
R₁ and R₂ are each independently methyl, ethyl, propyl, isopropyl, butyl, isobutyl, tertbutyl, or 2,4,4-trimethylpentan-2-yl.

4. The compound of claim 1, wherein:
R₁ and R₂ are the same as each other.

5. The compound of claim 1, wherein:
R₃ is hydrogen, deuterium, fluoro, chloro, cyano, or methyl.

6. The compound of claim 1, wherein:
R₃ is -N(Ar₁)(Ar₂), and
Ar₁ and Ar₂ are each independently phenyl, biphenylyl, terphenylyl, dimethylfluorenyl, diphenylfluorenyl, dimethylbenzofluorenyl, diphenylbenzofluorenyl, dibenzofuranyl, or dibenzothiophenyl,
wherein the Ar₁ and Ar₂ are each independently unsubstituted or substituted with one or two C₁₋₁₀ alkyls.

7. The compound of claim 1, wherein:
R₄ is hydrogen, deuterium, or a substituted or unsubstituted C₁₋₁₀ alkyl.

8. The compound of claim 1, wherein:
R₅ and R₆ are each independently hydrogen, deuterium, or a substituted or unsubstituted C₁₋₁₀ alkyl; or R₅ and R₆ are connected to each other to form

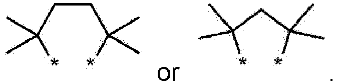

9. The compound of claim 1, wherein:
R₇ and R₈ are each independently hydrogen, deuterium, a substituted or unsubstituted C₁₋₁₀ alkyl, or phenyl unsubstituted or substituted with a C₁₋₁₀ alkyl; or R₇ and R₈ are connected to each other to form

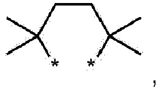

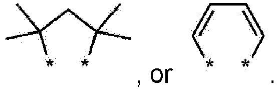

10. The compound of claim 1, wherein:
the compound represented by Chemical Formula 1 is any one selected from the group consisting of:

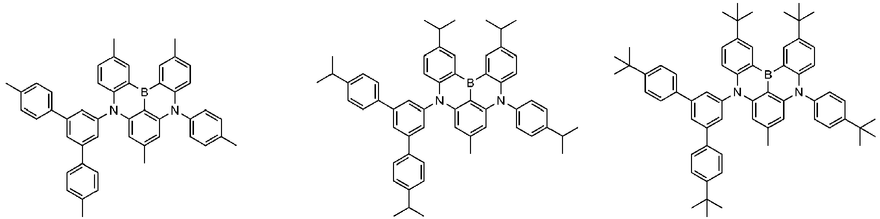

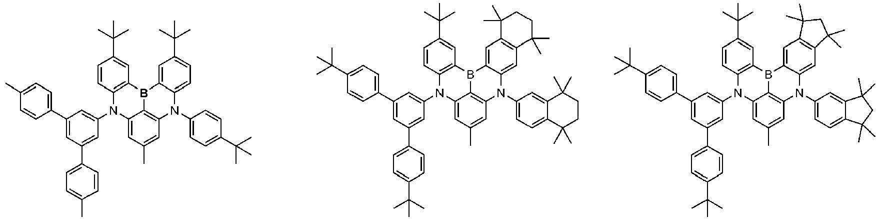

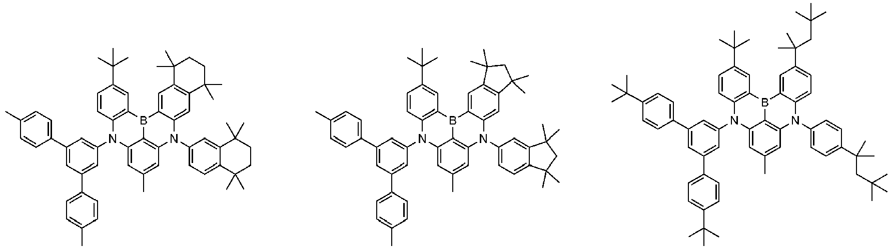

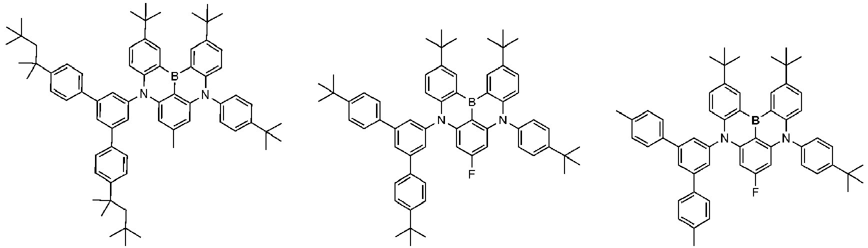

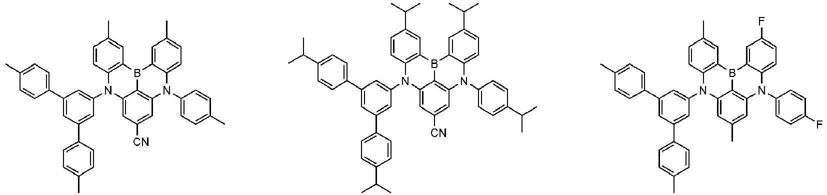

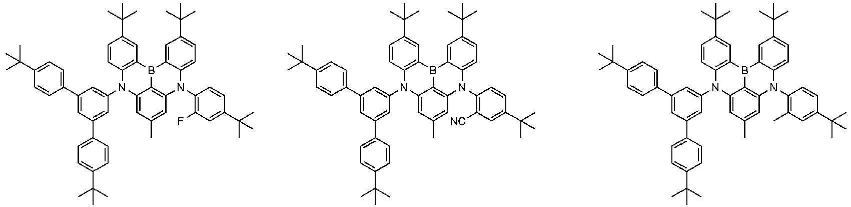

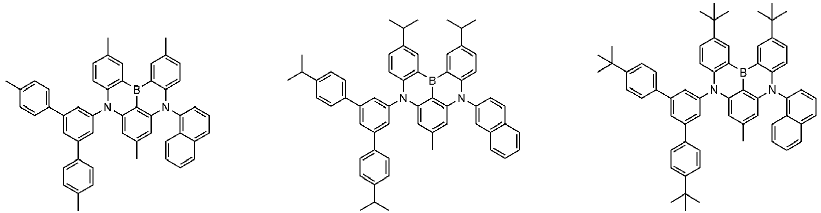

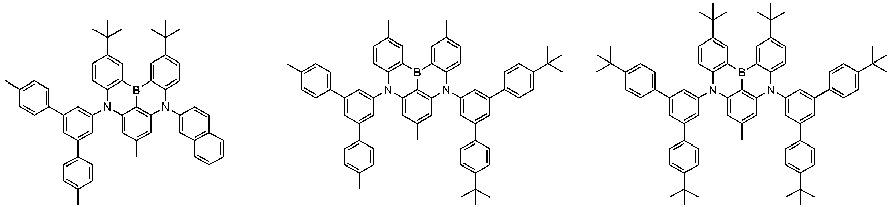

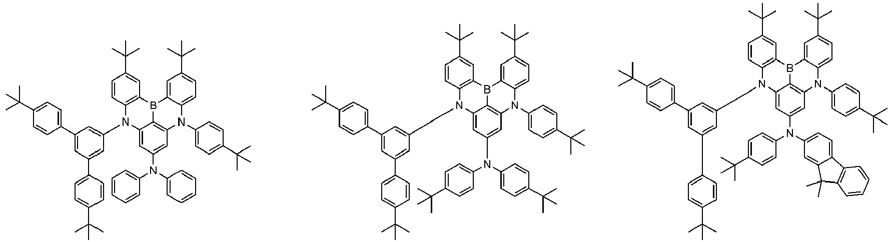

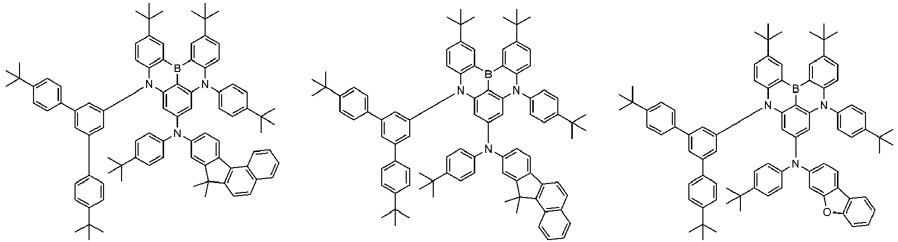

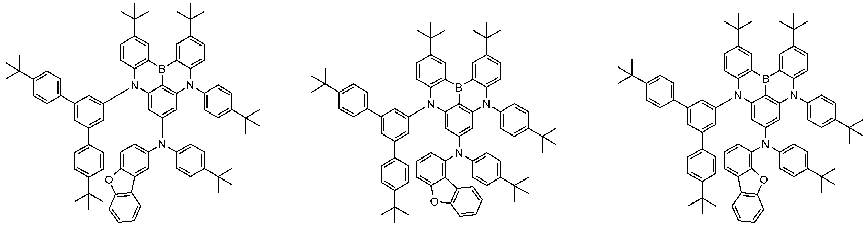

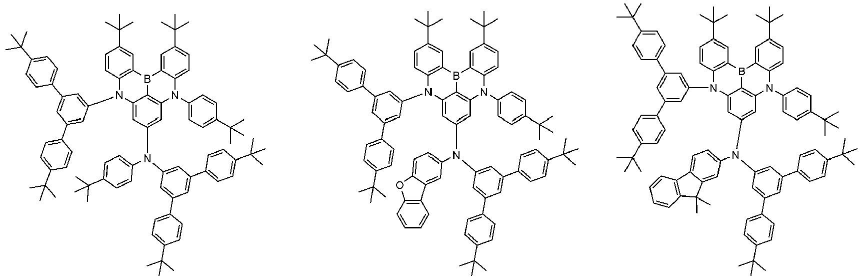

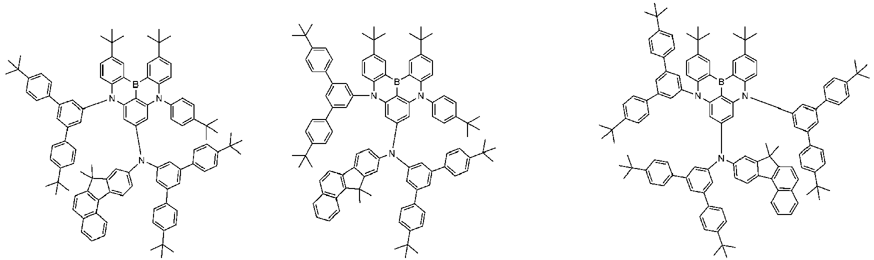

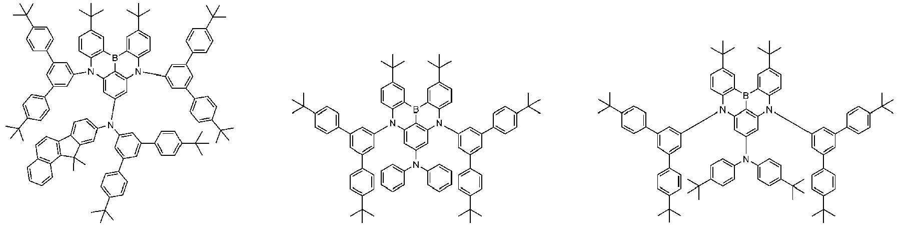

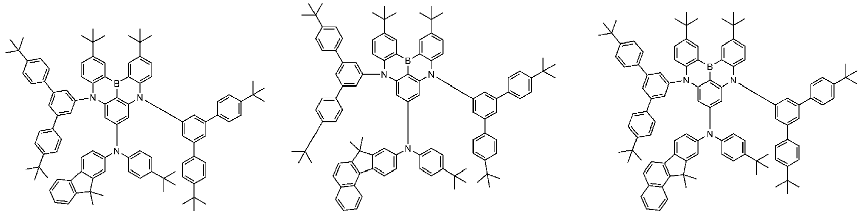

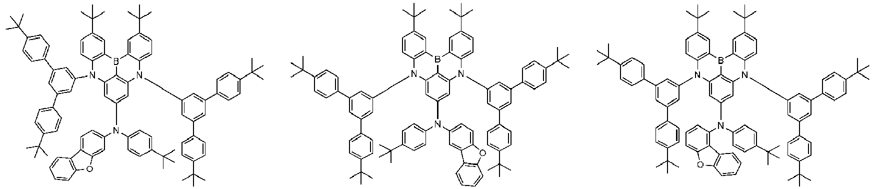

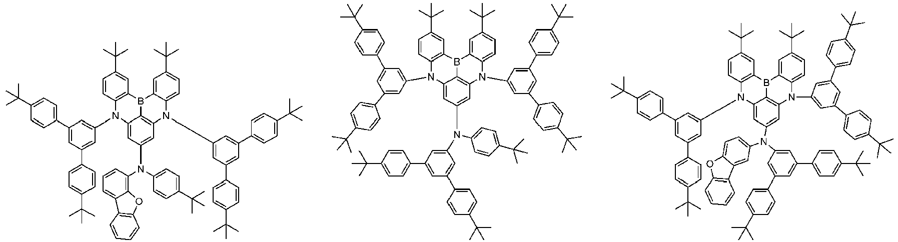

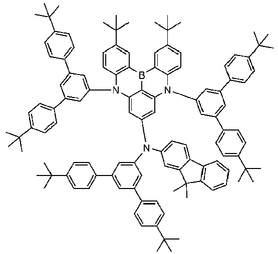

11. An organic light emitting device comprising: a first electrode; a second electrode that is provided opposite to the first electrode; and one or more organic material layers that are provided between the first electrode and the second electrode, wherein one or more layers of the organic material layers comprises the compound as set forth in any one of claims 1 to 10.

12. The organic light emitting device of claim 11, wherein:
the organic material layer comprising the compound is a light emitting layer.

## Patentansprüche

1. Verbindung, dargestellt durch die folgende chemische Formel 1: 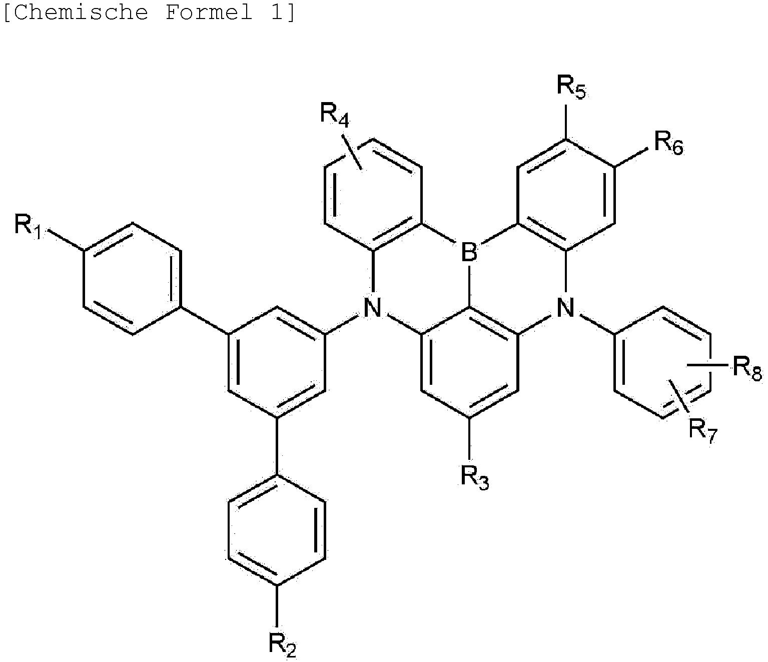
in der chemischen Formel 1
sind R₁ und R₂ jeweils unabhängig ein substituiertes oder unsubstituiertes C₁₋₆₀-Alkyl,
R₃ ist Wasserstoff, Deuterium, Cyano, ein substituiertes oder unsubstituiertes C₁₋₆₀-Alkyl oder -N(Ar₁)(Ar₂),
wobei das Ar₁ und Ar₂ jeweils unabhängig ein substituiertes oder unsubstituiertes C₆₋₆₀-Aryl oder ein substituiertes oder unsubstituiertes C₂₋₆₀-Heteroaryl sind, das ein oder mehrere Heteroatome, ausgewählt aus der Gruppe, bestehend aus N, O und S, enthält,
jedes R₄ unabhängig Wasserstoff, Deuterium, Halogen, Cyano, ein substituiertes oder unsubstituiertes C₁₋₆₀-Alkyl, ein substituiertes oder unsubstituiertes C₆₋₆₀-Aryl oder ein substituiertes oder unsubstituiertes C₂₋₆₀-Heteroaryl ist, das ein oder mehrere Heteroatome, ausgewählt aus der Gruppe, bestehend aus N, O und S, enthält,
R₅ und R₆ jeweils unabhängig Wasserstoff, Deuterium, Halogen, Cyano, ein substituiertes oder unsubstituiertes C₁₋₆₀-Alkyl, ein substituiertes oder unsubstituiertes C₆₋₆₀-Aryl oder ein substituiertes oder unsubstituiertes C₂₋₆₀-Heteroaryl sind, das ein oder mehrere Heteroatome, ausgewählt aus der Gruppe, bestehend aus N, O und S, enthält, oder R₅ und R₆ miteinander verbunden sind, um einen substituierten oder unsubstituierten alicyclischen C₃₋₁₀-Ring zu bilden, und
R₇ und R₈ jeweils unabhängig Wasserstoff, Deuterium, Halogen, Cyano, ein substituiertes oder unsubstituiertes C₁₋₆₀-Alkyl, ein substituiertes oder unsubstituiertes C₆₋₆₀-Aryl oder ein substituiertes oder unsubstituiertes C₂₋₆₀-Heteroaryl sind, das ein oder mehrere Heteroatome, ausgewählt aus der Gruppe, bestehend aus N, O und S, enthält, oder R₇ und R₈ miteinander verbunden sind, um einen substituierten oder unsubstituierten alicyclischen C₃₋₁₀-Ring oder einen substituierten oder unsubstituierten aromatischen C₆₋₁₀-Ring zu bilden.

2. Verbindung nach Anspruch 1, wobei
R₁ und R₂ jeweils unabhängig ein substituiertes oder unsubstituiertes C₁₋₁₀-Alkyl sind.

3. Verbindung nach Anspruch 1, wobei
R₁ und R₂ jeweils unabhängig Methyl, Ethyl, Propyl, Isopropyl, Butyl, Isobutyl, Tertbutyl oder 2,4,4-Trimethylpentan-2-yl sind.

4. Verbindung nach Anspruch 1, wobei
R₁ und R₂ gleich sind.

5. Verbindung nach Anspruch 1, wobei
R₃ Wasserstoff, Deuterium, Fluor, Chlor, Cyano oder Methyl ist.

6. Verbindung nach Anspruch 1, wobei
R₃ -N(Ar₁)(Ar₂) ist und
Ar₁ und Ar₂ jeweils unabhängig Phenyl, Biphenylyl, Terphenylyl, Dimethylfluorenyl, Diphenylfluorenyl, Dimethylbenzofluorenyl, Diphenylbenzofluorenyl, Dibenzofuranyl oder Dibenzothiophenyl sind,
wobei das Ar₁ und Ar₂ jeweils unabhängig unsubstituiert oder mit einem oder zwei C₁₋₁₀-Alkylen substituiert sind.

7. Verbindung nach Anspruch 1, wobei
R₄ Wasserstoff, Deuterium oder ein substituiertes oder unsubstituiertes C₁₋₁₀-Alkyl ist.

8. Verbindung nach Anspruch 1, wobei
R₅ und R₆ jeweils unabhängig Wasserstoff, Deuterium oder ein substituiertes oder unsubstituiertes C₁₋₁₀-Alkyl sind oder R₅ und R₆ miteinander verbunden sind, um 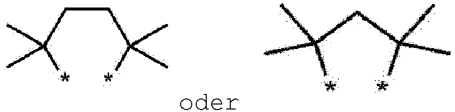 zu bilden.

9. Verbindung nach Anspruch 1, wobei
R₇ und R₈ jeweils unabhängig Wasserstoff, Deuterium, ein substituiertes oder unsubstituiertes C₁₋₁₀-Alkyl oder Phenyl sind, das unsubstituiert oder mit einem C₁₋₁₀-Alkyl substituiert ist, oder R₇ und R₈ miteinander verbunden sind, um 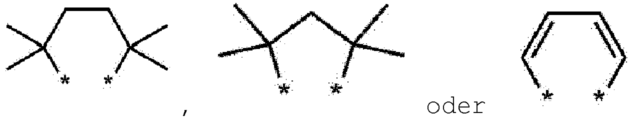 zu bilden.

10. Verbindung nach Anspruch 1, wobei
die durch die chemische Formel 1 dargestellte Verbindung eine ist, ausgewählt aus der Gruppe, bestehend aus:

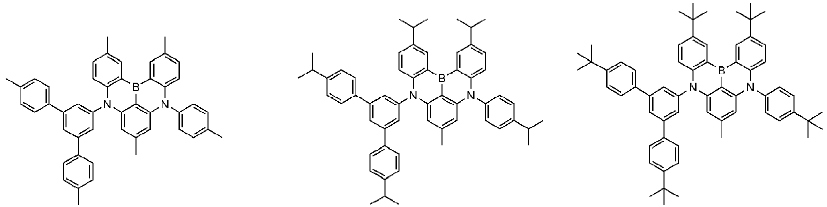

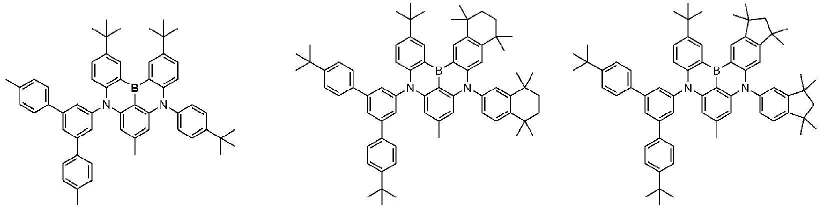

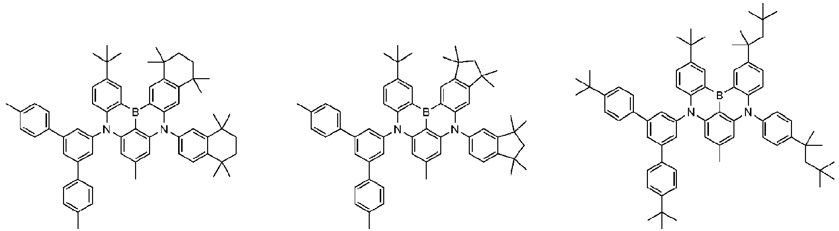

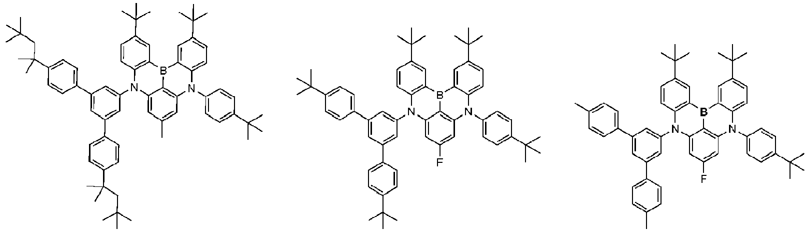

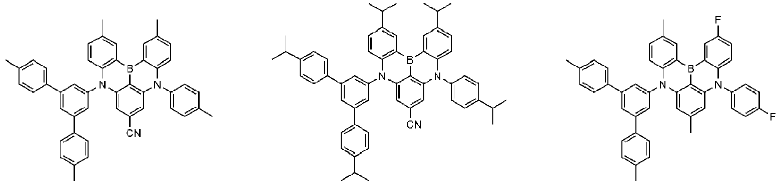

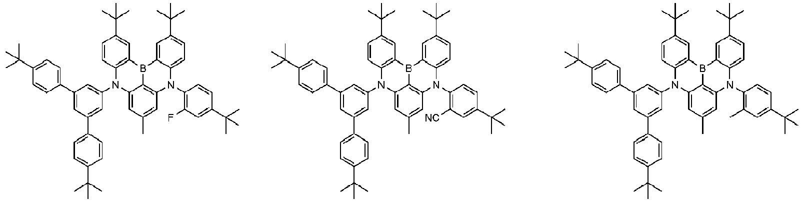

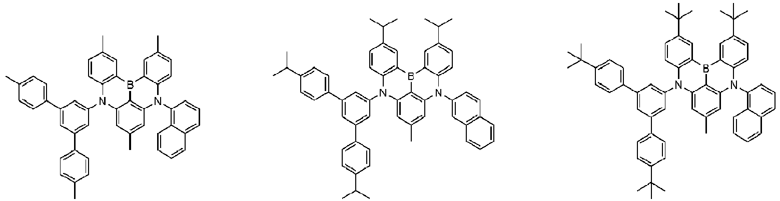

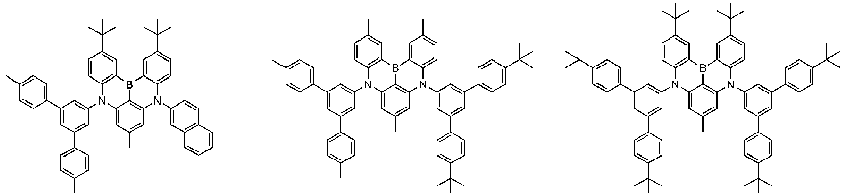

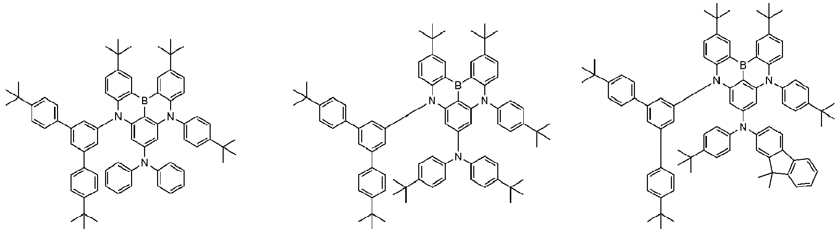

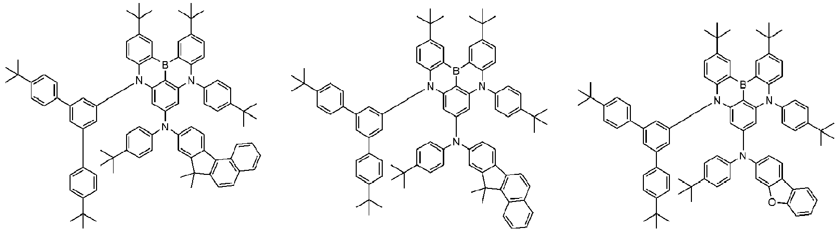

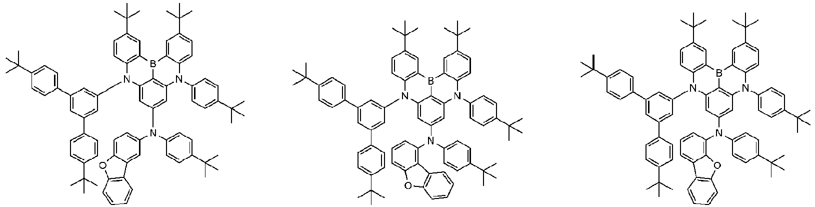

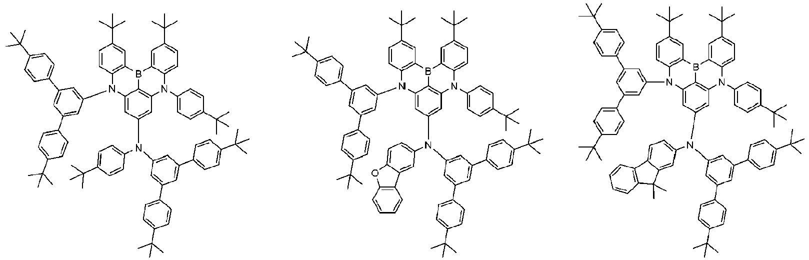

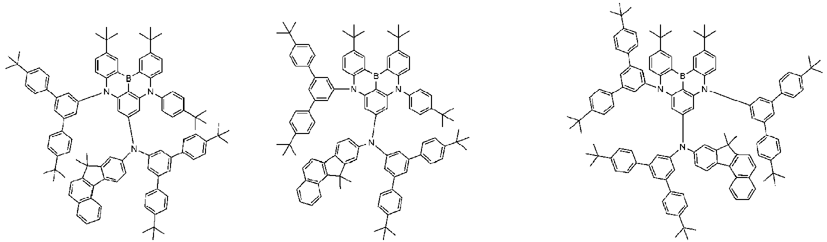

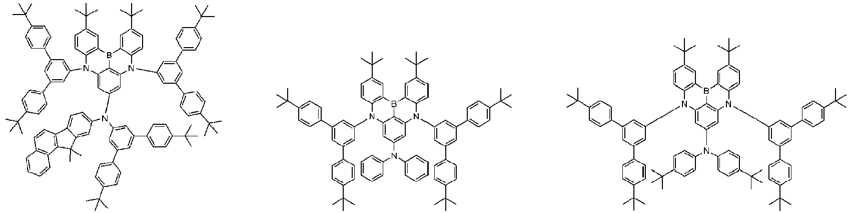

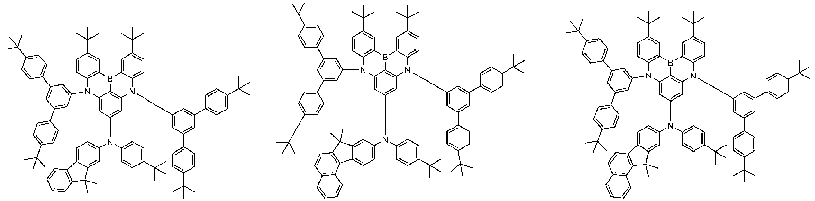

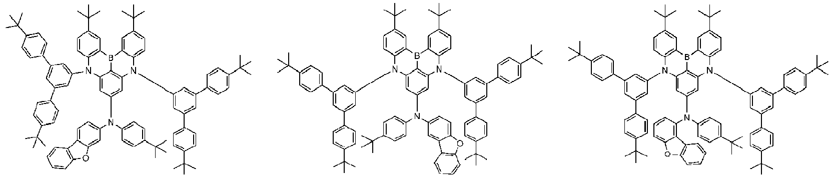

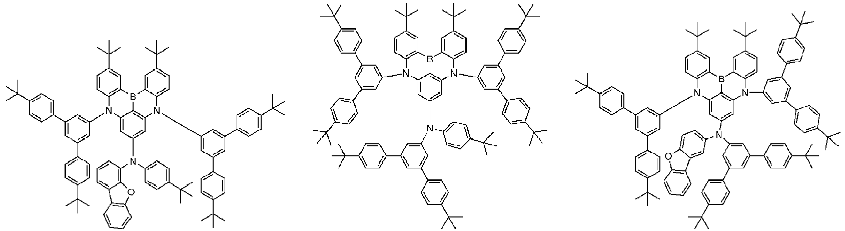

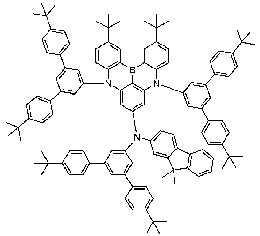

11. Organische lichtemittierende Vorrichtung, umfassend: eine erste Elektrode, eine zweite Elektrode, die sich gegenüber der ersten Elektrode befindet, und eine oder mehr Schichten aus organischem Material, die sich zwischen der ersten Elektrode und der zweiten Elektrode befinden, wobei eine oder mehr Schichten der Schichten aus organischem Material die Verbindung gemäß einem der Ansprüche 1 bis 10 umfasst.

12. Organische lichtemittierende Vorrichtung nach Anspruch 11, wobei
die Schicht aus organischem Material, die die Verbindung umfasst, eine lichtemittierende Schicht ist.

## Revendications

1. Composé représenté par la formule chimique 1 suivante : 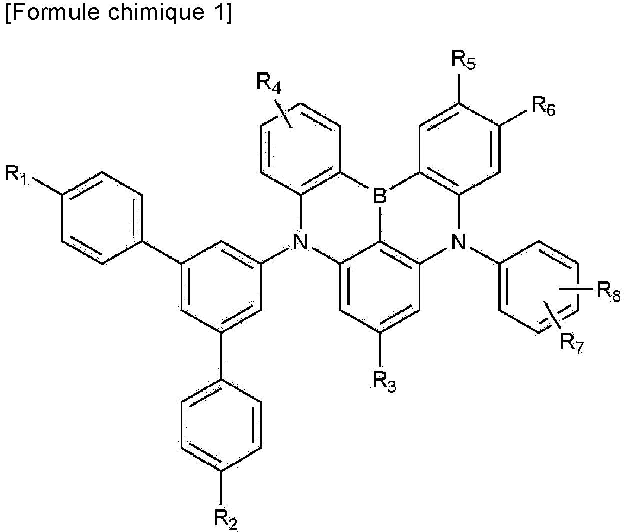
dans la formule chimique 1,
R₁ et R₂ sont chacun indépendamment un alkyle en C₁₋₆₀ substitué ou non substitué,
R₃ est hydrogène ; deutérium ; halogène ; cyano ; un alkyle en C₁₋₆₀ substitué ou non substitué ; ou -N(Ar₁)(Ar₂),
dans lequel le Ar₁ et le Ar₂ sont chacun indépendamment un aryle en C₆₋₆₀ substitué ou non substitué ; ou un hétéroaryle en C₂₋₆₀ substitué ou non substitué contenant un ou plusieurs hétéroatomes choisis dans le groupe constitué par N, O et S,
chaque R₄ est indépendamment hydrogène ; deutérium ; halogène ; cyano ; un alkyle en C₁₋₆₀ substitué ou non substitué ; un aryle en C₆₋₆₀ substitué ou non substitué ; ou un hétéroaryle en C₂₋₆₀ substitué ou non substitué contenant un ou plusieurs hétéroatomes choisis dans le groupe constitué par N, O et S,
R₅ et R₆ représentent chacun indépendamment hydrogène ; deutérium ; halogène ; cyano ; un alkyle en C₁₋₆₀ substitué ou non substitué ; un aryle en C₆₋₆₀ substitué ou non substitué ; ou un hétéroaryle en C₂₋₆₀ substitué ou non substitué contenant un ou plusieurs hétéroatomes choisis dans le groupe constitué par N, O et S ; ou R₅ et R₆ sont reliés l'un à l'autre pour former un cycle alicyclique en C₃₋₁₀ substitué ou non substitué, et
R₇ et R₈ sont chacun indépendamment hydrogène ; deutérium ; halogène ; cyano ; un alkyle en C₁₋₆₀ substitué ou non substitué ; un aryle en C₆₋₆₀ substitué ou non substitué ; ou un hétéroaryle en C₂₋₆₀ substitué ou non substitué contenant un ou plusieurs hétéroatomes choisis dans le groupe constitué par N, O et S ; ou R₇ et R₈ sont reliés l'un à l'autre pour former un cycle alicyclique en C₃₋₁₀ substitué ou non substitué ou un cycle aromatique en C₆₋₁₀ substitué ou non substitué.

2. Composé selon la revendication 1, dans lequel :
R₁ et R₂ sont chacun indépendamment un alkyle en C₁₋₁₀ substitué ou non substitué.

3. Composé selon la revendication 1, dans lequel :
R₁ et R₂ sont chacun indépendamment méthyle, éthyle, propyle, isopropyle, butyle, isobutyle, tertbutyle, ou 2,4,4-triméthylpentan-2-yle.

4. Composé selon la revendication 1, dans lequel :
R₁ et R₂ sont identiques l'un à l'autre.

5. Composé selon la revendication 1, dans lequel :
R₃ est hydrogène, deutérium, fluoro, chloro, cyano, ou méthyle.

6. Composé selon la revendication 1, dans lequel :
R₃ est -N(Ar₁)(Ar₂), et
Ar₁ et Ar₂ sont chacun indépendamment phényle, biphénylyle, terphénylyle, diméthylfluorényle, diphénylfluorényle, diméthylbenzofluorényle, diphénylbenzofluorényle, dibenzofuranyle, ou dibenzothiophényle,
dans lequel le Ar₁ et le Ar₂ sont chacun indépendamment non substitués ou substitués par un ou deux alkyles en C₁₋₁₀.

7. Composé selon la revendication 1, dans lequel :
R₄ est hydrogène, deutérium, ou un alkyle en C₁₋₁₀ substitué ou non substitué.

8. Composé selon la revendication 1, dans lequel :
R₅ et R₆ sont chacun indépendamment hydrogène, deutérium, ou un alkyle en C₁₋₁₀ substitué ou non substitué ; ou R₅ et R₆ sont reliés l'un à l'autre pour former

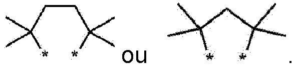

9. Composé selon la revendication 1, dans lequel :
R₇ et R₈ sont chacun indépendamment hydrogène, deutérium, un alkyle en C₁₋₁₀ substitué ou non substitué, ou un phényle non substitué ou substitué par un alkyle en C₁₋₁₀ ; ou R₇ et R₈ sont reliés l'un à l'autre pour former 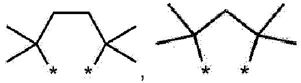 ou

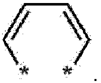

10. Composé selon la revendication 1, dans lequel :
le composé représenté par la formule chimique 1 est l'un quelconque choisi dans le groupe constitué par :

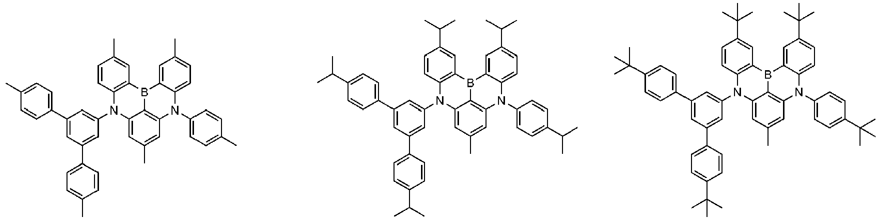

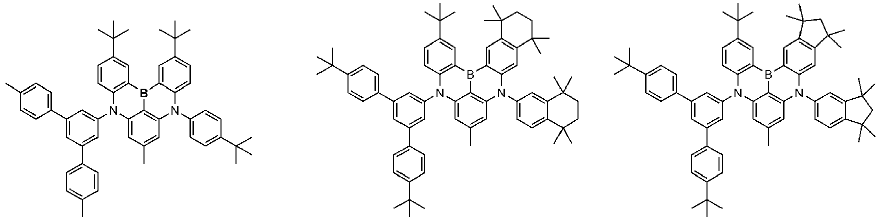

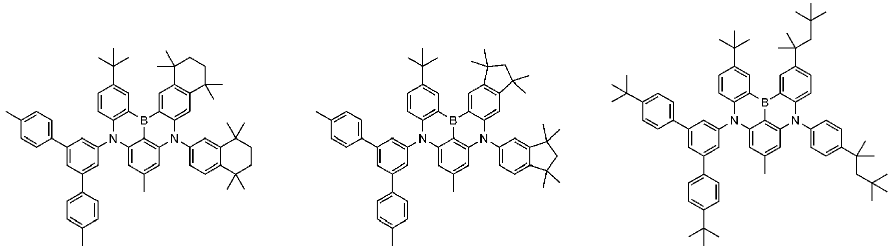

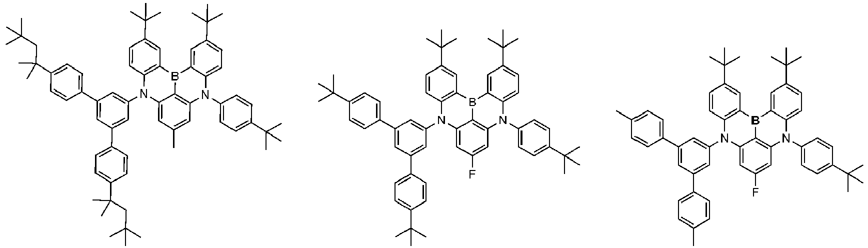

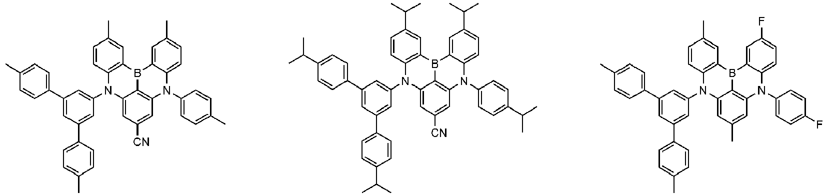

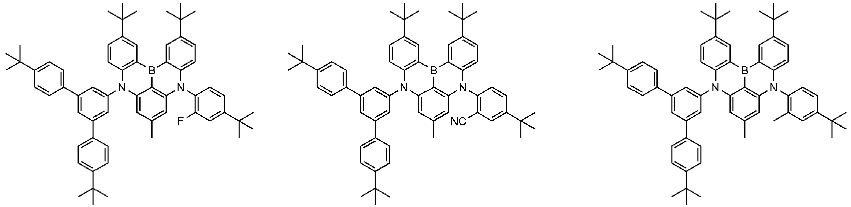

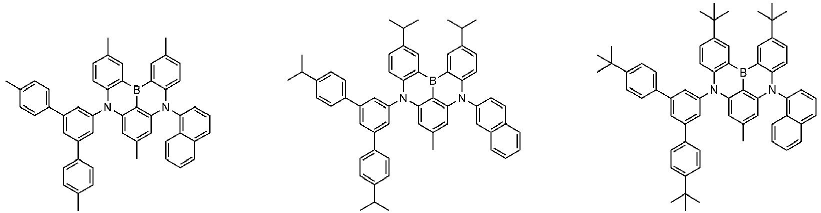

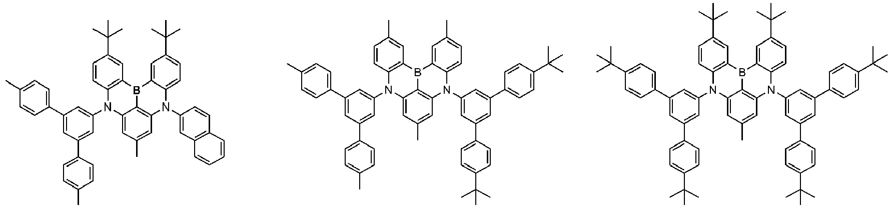

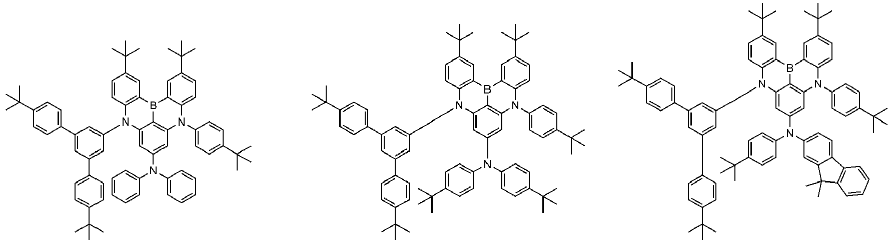

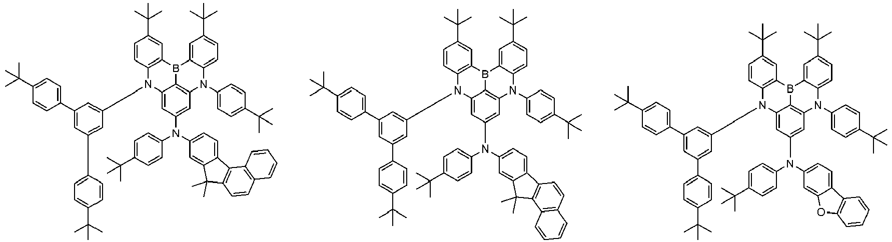

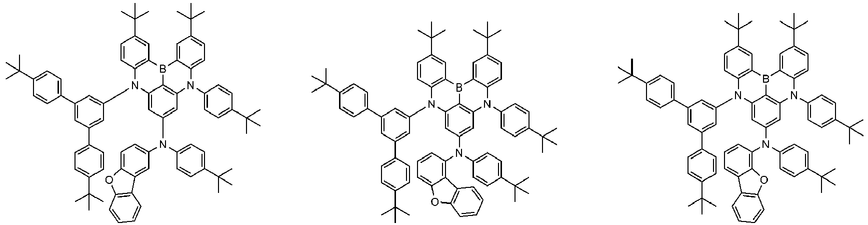

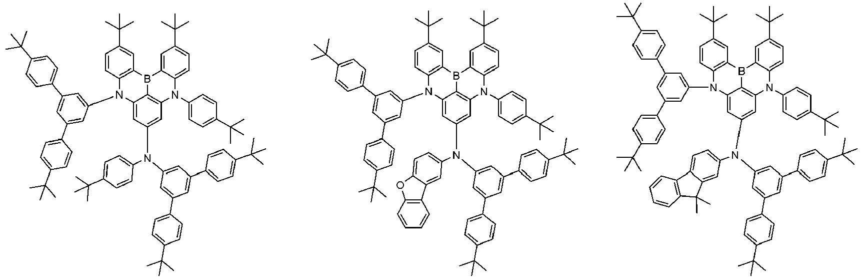

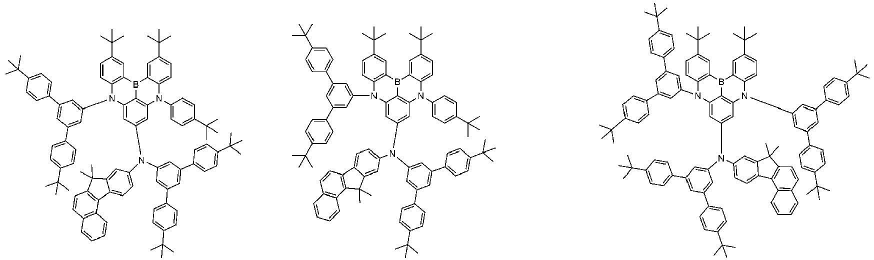

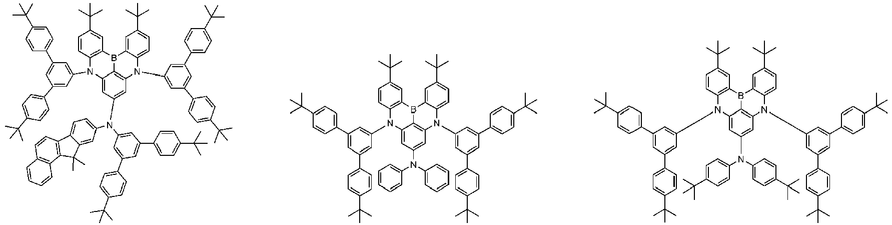

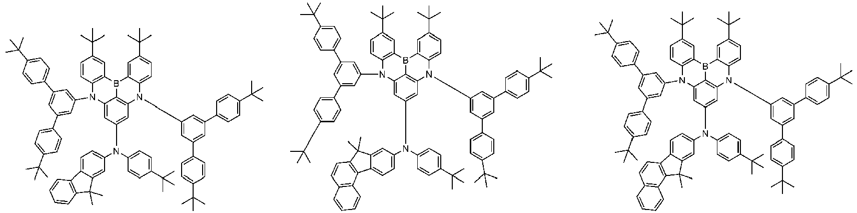

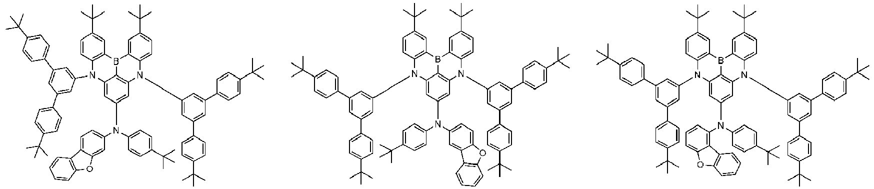

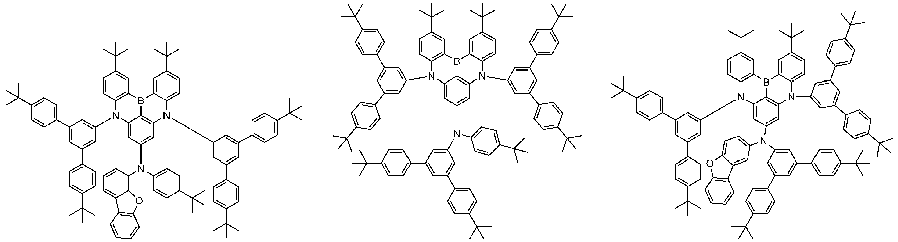

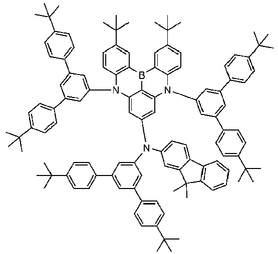

11. Dispositif électroluminescent organique comprenant : une première électrode ; une seconde électrode qui est disposée à l'opposé de la première électrode ; et une ou plusieurs couches de matériau organique qui sont disposées entre la première électrode et la seconde électrode, dans lequel une ou plusieurs couches des couches de matériau organique comprennent le composé décrit dans l'une quelconque des revendications 1 à 10.

12. Dispositif électroluminescent organique selon la revendication 11, dans lequel :
la couche de matériau organique comprenant le composé est une couche électroluminescente.
